(19) Europäisches Patentamt
European Patent Office
Office européen des brevets

(11) **EP 3 438 762 B1**

(12) **FASCICULE DE BREVET EUROPEEN**

(45) Date de publication et mention
de la délivrance du brevet:
**29.04.2026 Bulletin 2026/18**

(21) Numéro de dépôt: **18185138.7**

(22) Date de dépôt: **24.07.2018**

(51) Classification Internationale des Brevets (IPC):
**G04B 17/04** *(2006.01)*     **G04B 31/02** *(2006.01)*
**B81B 3/00** *(2006.01)*

(52) Classification Coopérative des Brevets (CPC):
**G04B 17/045; B81B 3/0045; G04B 31/02**

(54) **OSCILLATEUR D'HORLOGERIE A GUIDAGES FLEXIBLES A GRANDE COURSE ANGULAIRE**

UHRWERKOSZILLATOR MIT FLEXIBLEN FÜHRUNGEN MIT GROSSER WINKELFÖRMIGER LAUFBAHN

TIMEPIECE OSCILLATOR HAVING FLEXIBLE GUIDES WITH WIDE ANGULAR TRAVEL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.07.2017 EP 17183666**
**25.06.2018 EP 18179623**

(43) Date de publication de la demande:
**06.02.2019 Bulletin 2019/06**

(73) Titulaire: **The Swatch Group Research and Development Ltd**
**2074 Marin (CH)**

(72) Inventeurs:
• **Di Domenico, Gianni**
**2000 Neuchâtel (CH)**
• **Cusin, Pierre**
**1423 Villars-Burquin (CH)**
• **Helfer, Jean-Luc**
**2525 Le Landeron (CH)**

• **Gandelhman, Alex**
**2013 Colombier (CH)**
• **Winkler, Pascal**
**2072 St-Blaise (CH)**
• **Hinaux, Baptiste**
**1003 Lausanne (CH)**
• **Léchot, Dominique**
**2722 Les Reussilles (CH)**
• **Matthey, Olivier**
**1453 Mauborget (CH)**
• **Klinger, Laurent**
**2503 Bienne (CH)**
• **Favre, Jérôme**
**2000 Neuchâtel (CH)**

(74) Mandataire: **ICB SA**
**Faubourg de l'Hôpital, 3**
**2001 Neuchâtel (CH)**

(56) Documents cités:
**EP-A1- 3 324 247     EP-A1- 3 327 515**
**EP-A2- 2 998 800**

## Description

<u>Domaine de l'invention</u>

L'invention concerne un oscillateur mécanique d'horlogerie, comportant entre un élément support rigide et un élément inertiel massif, un guidage flexible avec au moins deux premières lames flexibles qui supportent ledit élément inertiel massif et sont agencées pour le rappeler vers une position de repos, ledit élément inertiel massif étant agencé pour osciller angulairement selon un plan d'oscillation autour de ladite position de repos, lesdites deux premières lames flexibles ne se touchant pas et leurs projections sur ledit plan d'oscillation se croisant, en position de repos, en un point de croisement, au voisinage immédiat duquel ou par lequel passe l'axe de rotation dudit élément inertiel massif perpendiculairement audit plan d'oscillation, et les encastrements desdites premières lames flexibles avec ledit élément support rigide et ledit élément inertiel massif définissant au moins deux directions de lames parallèles audit plan d'oscillation.

L'invention concerne encore un mouvement d'horlogerie comportant au moins un tel oscillateur mécanique.

L'invention concerne encore une montre comportant un tel mouvement d'horlogerie.

L'invention concerne le domaine des oscillateurs mécaniques d'horlogerie comportant des guidages à lames flexibles assurant les fonctions de maintien et de rappel d'éléments mobiles.

<u>Arrière-plan de l'invention</u>

L'utilisation de guidages flexibles, notamment à lames souples, dans des oscillateurs mécaniques d'horlogerie, est rendue possible par des procédés d'élaboration, tels que « MEMS », « LIGA » ou similaires, de matériaux micro-usinables, tels que le silicium et ses oxydes, qui permettent une fabrication très reproductible de composants qui présentent des caractéristiques élastiques constantes dans le temps et une grande insensibilité aux agents extérieurs tels que température et humidité. Des pivots à guidage flexible, tels que décrits dans les demandes EP3035126A1 ou EP3206089A1 du même déposant, permettent notamment de remplacer le pivot d'un balancier classique, ainsi que le ressort-spiral qui lui est usuellement associé. La suppression des frottements de pivots permet d'augmenter substantiellement le facteur de qualité d'un oscillateur. Toutefois les pivots à guidage flexible ont généralement une course angulaire faible, de l'ordre de 10° à 20°, ce qui est très faible en comparaison de l'amplitude usuelle de 300° d'un balancier-spiral, et qui n'autorise pas leur combinaison directe avec des mécanismes d'échappement classiques, et notamment avec des arrêtoirs usuels tels qu'une ancre suisse ou similaire, qui exigent une grande course angulaire pour assurer leur bon fonctionnement.

Lors du Congrès de Chronométrie de Montreux, Suisse, des 28 et 29 septembre 2016, l'équipe de M. H. Kahrobaiyan a abordé l'augmentation de cette course angulaire dans l'article « Gravity insensitive flexure pivots for watch oscillators », et il apparaît que la solution -complexe- envisagée n'est pas isochrone.

Le document EP3035127A1 au nom du même déposant SWATCH GROUP RESEARCH & DEVELOPMENT Ltd décrit un oscillateur d'horlogerie comportant une base de temps avec au moins un résonateur constitué par un diapason lequel comporte au moins deux parties mobiles oscillantes, lesdites parties mobiles étant fixées à un élément de liaison, que comporte ledit oscillateur, par des éléments flexibles dont la géométrie détermine un axe de pivotement virtuel de position déterminée par rapport audit élément de liaison, autour duquel axe de pivotement virtuel oscille ladite partie mobile respective, dont le centre de masse est confondu en position de repos avec ledit axe de pivotement virtuel respectif. Pour au moins une dite partie mobile, lesdits éléments flexibles sont constitués de lames élastiques croisées et s'étendant à distance l'une de l'autre dans deux plans parallèles, et dont les projections des directions sur un desdits plans parallèles se croisent au niveau dudit axe de pivotement virtuel, de ladite partie mobile considérée.

Le document US3628781A au nom de GRIB décrit une fourche de diapason, sous la forme d'une structure en porte-à-faux double, pour permettre un mouvement de rotation accentué d'une paire d'éléments mobiles, par rapport à un plan de référence fixe comprenant un premier corps élastiquement déformable ayant au moins deux parties flexibles allongées élastiquement similaires, les extrémités de chacune desdites parties flexibles étant respectivement solidaire de parties rigides agrandies dudit élément, la première desdites parties rigides étant fixée pour définir un plan de référence et la seconde étant supportée élastiquement pour avoir un mouvement de rotation accentué par rapport à la première, un second corps déformable élastiquement sensiblement identique au premier corps déformable élastiquement, et des moyens pour fixer rigidement les premières desdites parties rigides respectives desdits corps élastiquement déformables en relation espacée pour fournir une structure de fourche de diapason dans laquelle chacune des dents du diapason comprend l'extrémité libre de l'un desdits corps élastiquement déformables.

Le document EP3324247A1 au nom du même déposant SWATCH GROUP RESEARCH & DEVELOPMENT Ltd décrit un résonateur à lame pour mouvement mécanique de montre, agencé pour être fixé sur une platine d'un mouvement ou pour constituer une platine, le résonateur comportant une structure fixe, agencée pour être fixée sur la platine ou pour constituer la platine, et par rapport à laquelle structure fixe au moins un élément inertiel est agencé pour vibrer ou/et osciller, et le résonateur comportant au moins une lame élastique s'étendant entre, à une première extrémité un premier

**EP 3 438 762 B1**

ancrage agencé au niveau de la structure fixe et à une deuxième extrémité un deuxième ancrage agencé au niveau d'un au moins un élément inertiel, et la lame étant agencée pour vibrer essentiellement dans un plan principal. Cette lame constitue un guidage de l'élément inertiel dans le plan principal. Pour la protection antichoc des lames qu'il comporte, le résonateur comporte au moins, au niveau du premier ancrage ou/et au niveau du deuxième ancrage, au moins un dispositif antichoc plan agencé pour protéger chaque lame de la rupture en cas de choc, ce dispositif antichoc plan comportant au moins un premier élément flexible précontraint avec un effort de précontrainte dans le plan principal ajusté à une valeur d'effort de sécurité prédéterminée.

Le document EP2998800A2 au nom de PATEK PHILIPPE décrit un composant horloger à pivot flexible, comprenant une première pièce monolithique définissant une première partie rigide et une deuxième partie rigide reliées par au moins une première lame élastique, et une deuxième pièce monolithique définissant une troisième partie rigide et une quatrième partie rigide reliées par au moins une deuxième lame élastique, les première et deuxième pièces monolithiques étant assemblées l'une à l'autre de telle sorte que les première et troisième parties rigides soient solidaires l'une de l'autre, les deuxième et quatrième parties rigides soient solidaires l'une de l'autre. La au moins une première lame élastique et la au moins une deuxième lame élastique se croisent sans contact et définissent un axe de rotation virtuel pour les deuxième et quatrième parties rigides, par rapport aux première et troisième parties rigides. Ce composant comprend un palier, solidaire des deuxième et quatrième parties rigides, et destiné à guider la rotation d'un élément mobile autour d'un axe distinct de l'axe de rotation virtuel et sensiblement parallèle à ce dernier.

Le document EP3130966A1 au nom de ETA Manufacture Horlogère Suisse décrit un mouvement d'horlogerie mécanique qui comprend au moins un barillet, un ensemble de roues d'engrenage entraîné à une extrémité par le barillet, et un mécanisme d'échappement d'un oscillateur local avec un résonateur sous forme d'un balancier-spiral et un système de rétroaction du mouvement d'horlogerie. Le mécanisme d'échappement est entraîné à une autre extrémité de l'ensemble de roues d'engrenage. Le système de rétroaction comprend au moins un oscillateur de référence précis, combiné à un comparateur de marche pour comparer la marche des deux oscillateurs, et un mécanisme de réglage du résonateur de l'oscillateur local pour ralentir ou accélérer le résonateur sur la base d'un résultat de la comparaison dans le comparateur de marche.

Le document CH709536A2 au nom de ETA Manufacture Horlogère Suisse décrit un mécanisme régulateur d'horlogerie comportant, montés mobiles, au moins en pivotement par rapport à une platine, une roue d'échappement agencée pour recevoir un couple moteur via un rouage, et un premier oscillateur comportant une première structure rigide reliée à ladite platine par des premiers moyens de rappel élastique. Ce mécanisme régulateur comporte un deuxième oscillateur comportant une deuxième structure rigide reliée à ladite première structure rigide par des deuxièmes moyens de rappel élastique, et qui comporte des moyens de guidage agencés pour coopérer avec des moyens de guidage complémentaire que comporte ladite roue d'échappement, synchronisant ledit premier oscillateur et ledit deuxième oscillateur avec ledit rouage.

La demande de brevet EP3435170A1 du même déposant, incorporée ici par référence, décrit un pivot à grande course angulaire. En utilisant un angle entre les lames d'environ 25° à 30°, et un point de croisement situé à environ 45% de leur longueur, il est possible d'obtenir simultanément un bon isochronisme et une insensibilité aux positions sur une grande course angulaire (jusqu'à 40° ou plus). Afin de maximiser la course angulaire tout en conservant une bonne rigidité hors plan, on tend à affiner les lames tout en augmentant leur hauteur. L'utilisation d'une grande valeur du rapport d'aspect, c'est-à-dire du rapport entre la hauteur de la lame sur son épaisseur est théoriquement avantageuse, mais dans la pratique on rencontre souvent des phénomènes de courbure anticlastique, qui altèrent les propriétés.

Résumé de l'invention

L'invention se propose de mettre au point un oscillateur mécanique à guidages flexibles, dont la course angulaire soit compatible avec des mécanismes d'échappement existants, et dont les guidages flexibles se comportent de façon régulière quelle que soit leur déformation.

Ce résonateur à guidage flexible en rotation doit posséder les propriétés suivantes :

-	un facteur de qualité élevé ;
-	une grande course angulaire ;
-	un bon isochronisme ;
-	une grande insensibilité aux positions dans l'espace.

En considérant le cas particulier d'un guidage flexible à lames croisées en projection dans un plan parallèle au plan d'oscillation, où ces lames joignent une masse fixe et une masse mobile, la course angulaire possible θ du pivot dépend du rapport X= D/L entre, d'une part la distance D du point d'encastrement d'une lame dans la masse fixe et le point de croisement, et d'autre part la longueur totale L de cette même lame, dans son élongation, entre ses deux encastrements opposés. Les travaux cités ci-dessus de l'équipe de M. H. Kahrobaiyan montrent que cette course angulaire

3

possible θ est, pour un couple de lames donné et d'angle au sommet α donné au point de croisement, ici de 90°, maximale pour X= D/L= 0.5, et décroît rapidement quand on s'écarte de cette valeur, selon une courbe sensiblement symétrique. Or un tel pivot à lames croisées avec X= D/L= 0.5 et α=90° n'est pas isochrone.

L'invention explore de ce fait les domaines de combinaisons favorables entre les valeurs d'angle au sommet α au croisement des lames, et les valeurs du rapport X= D/L, pour obtenir des pivots isochrones, ainsi que les valeurs optimales du rapport d'aspect de chacune des lames.

A cet effet, l'invention concerne un oscillateur mécanique selon la revendication 1 ou selon la revendication 2.

Et notamment l'invention montre que l'on peut obtenir un oscillateur isochrone avec des pivots qui vérifient à la fois les deux inégalités : 0.15≤(X= D/L)≤0.85, et α≤60°.

Naturellement les configurations avec α=0° sont écartées, les lames n'étant alors plus sécantes en projection, mais parallèles.

L'invention concerne encore un mouvement d'horlogerie comportant au moins un tel oscillateur mécanique.

L'invention concerne encore une montre comportant un tel mouvement d'horlogerie.

Description sommaire des dessins

D'autres caractéristiques et avantages de l'invention apparaîtront à la lecture de la description détaillée qui va suivre, en référence aux dessins annexés, où :

- la figure 1 représente, de façon schématisée, et en perspective, une première variante d'oscillateur mécanique, qui comporte un élément support rigide, de forme allongée, pour sa fixation à une platine du mouvement ou similaire, auquel est suspendu un élément inertiel massif par deux premières flexibles disjointes, croisées en projection sur le plan d'oscillation de cet élément inertiel, lequel coopère avec un mécanisme d'échappement classique avec ancre suisse et roue d'échappement standard ;
- la figure 2 représente, de façon schématisée, et en plan, l'oscillateur de la figure 1 ;
- la figure 3 représente, de façon schématisée, et en coupe passant par l'axe de croisement des lames, l'oscillateur de la figure 1 ;
- la figure 4 représente, de façon schématisée, un détail de la figure 2, montrant le décalage entre le croisement des lames et la projection du centre de masse du résonateur, ce détail avec décalage étant applicable de la même façon aux différentes variantes décrites ci-après;
- la figure 5 est un graphe, avec en abscisse rapport X= D/L entre, d'une part la distance D du point d'encastrement d'une lame dans la masse fixe et le point de croisement, et d'autre part la longueur totale L de cette même lame entre ses deux encastrements opposés, et en ordonnées l'angle au sommet de croisement des lames flexibles, et qui définit deux courbes, inférieure et supérieure, en trait interrompu, qui bornent le domaine convenable entre ces paramètres pour assurer l'isochronisme, la courbe en trait plein correspondant à une valeur avantageuse ;
- la figure 6 représente, de façon similaire à la figure 1, une deuxième variante d'oscillateur mécanique, où l'élément support rigide, de forme allongée, est aussi mobile par rapport à une structure fixe, et est porté par un troisième élément rigide, par l'intermédiaire d'un second jeu de lames flexibles, agencées de façon similaire au premières lames flexibles, l'élément inertiel étant encore agencé pour coopérer avec un mécanisme d'échappement classique non représenté ;
- la figure 7 représente, de façon schématisée, et en plan, l'oscillateur de la figure 6;
- la figure 8 représente, de façon schématisée, et en coupe passant par l'axe de croisement des lames, l'oscillateur de la figure 1 ;
- la figure 9 est un schéma-blocs représentant une montre qui comporte un mouvement avec un tel résonateur ;

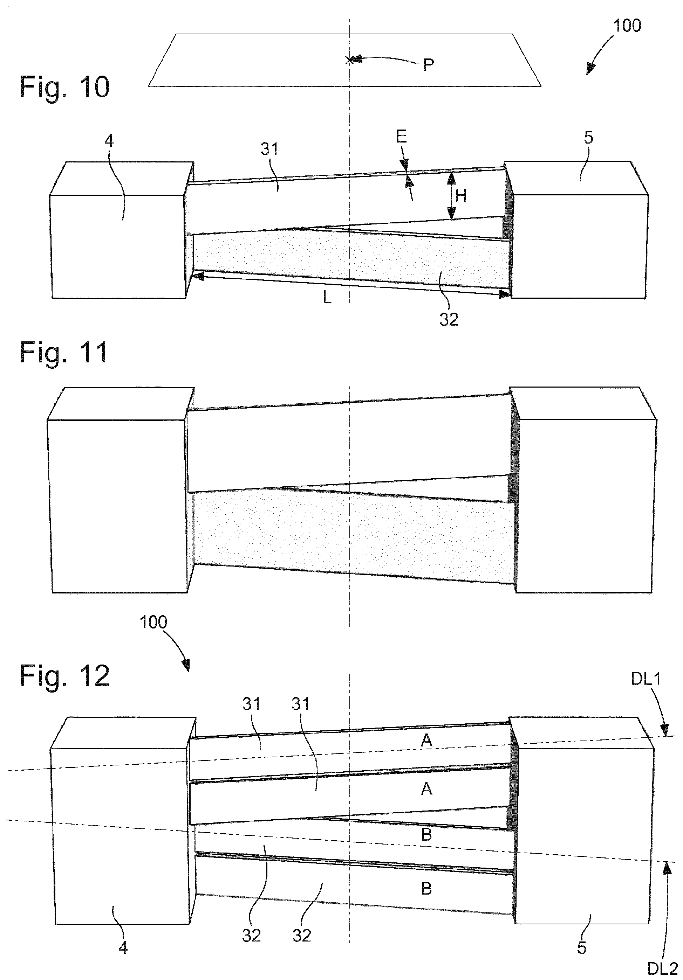

- la figure 10 représente, de façon schématisée et en perspective, un guidage à lames flexibles croisées en projection, entre une structure fixe et un élément inertiel ;
- la figure 11 représente, de façon similaire à la figure 10, un guidage flexible théorique dont chaque lame a un rapport d'aspect supérieur à celui des lames de la figure 10 ;
- la figure 12 représente, de façon similaire à la figure 10, un guidage flexible, équivalent en termes de rappel élastique au guidage théorique de la figure 11, mais comportant un nombre supérieur de lames, dont chacune a un rapport d'aspect inférieur à 10, dans cette variante deux lames élémentaires d'un premier type sont superposées dans une première direction, et croisent en projection deux lames élémentaires d'un deuxième type qui sont aussi superposées entre elles et s'étendent dans une deuxième direction ;

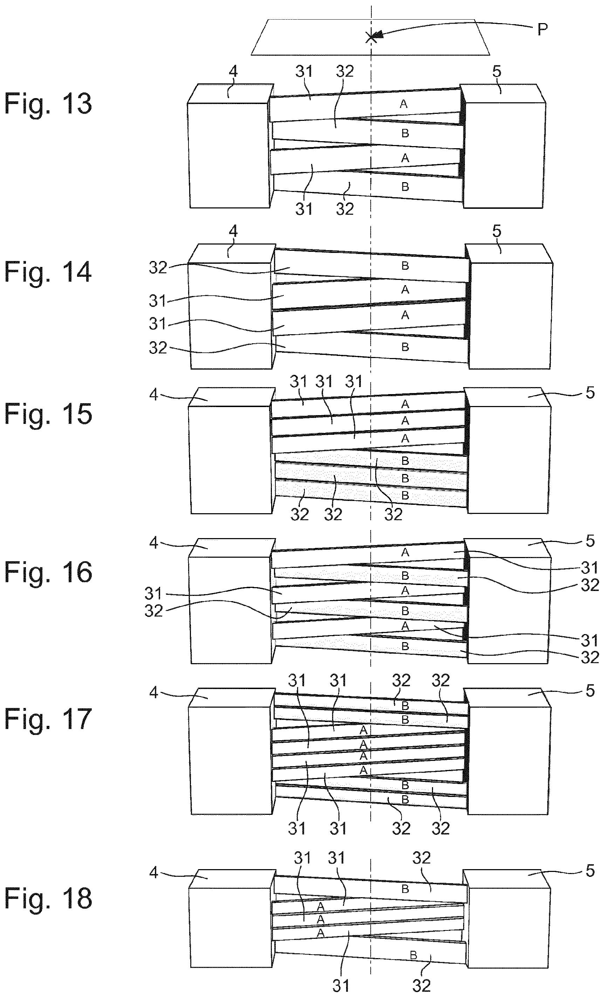

- la figure 13 représente, de façon similaire à la figure 12, un autre guidage flexible, dont les quatre lames sont en quinconce ;
- la figure 14 représente, de façon similaire à la figure 12, encore un autre guidage flexible, dont les quatre lames comportent deux lames élémentaires d'un premier type dans une première direction, qui encadrent deux lames élémentaires d'un deuxième type qui sont superposées entre elles et s'étendent dans une deuxième direction ;

- la figure 15 représente, de façon similaire à la figure 12, un autre guidage flexible, comportant six lames superposées par trois ;
- la figure 16 représente, de façon similaire à la figure 13, un autre guidage flexible, dont les six lames sont en quinconce ;
- la figure 17 représente, de façon similaire à la figure 14, un autre guidage flexible, dont les huit lames comportent une première et une deuxième superposition de deux lames élémentaires d'un premier type dans une première direction, qui encadrent quatre lames élémentaires d'un deuxième type qui sont superposées entre elles et s'étendent dans une deuxième direction ;
- la figure 18 représente, de façon similaire à la figure 12, encore un autre guidage flexible, à nombre inégal de lames, dont les cinq lames comportent deux lames élémentaires d'un premier type dans une première direction, qui encadrent trois lames élémentaires d'un deuxième type qui sont superposées entre elles et s'étendent dans une deuxième direction ;
- la figure 19 est identique à la figure 13, et la figure 20 montre la décomposition de ce guidage flexible à quatre lames alternées en deux sous-unités de pivots à deux lames ;
- la figure 21 est identique à la figure 14, et la figure 22 montre la décomposition de ce guidage flexible à quatre lames encadrées en deux sous-unités de pivots à deux lames ;
- la figure 23 représente, de façon schématisée, et, ramenés dans le même plan, la partie supérieure et la partie inférieure d'un oscillateur avec un tel guidage flexible décomposé en plusieurs sous-unités, dans le cas d'espèce un étage supérieur et un étage inférieur, avec des tables de translation interposées entre le support fixe et l'appui des lames vers l'élément inertiel, ces tables de translation comportant des guidages élastiques souples selon les directions X et Y des bissectrices aux directions en projection des lames ;
- la figure 24 est similaire à la figure 23, et comporte un réglage de position en X sur une partie rigide inférieure, de façon à modifier l'écart entre les projections des croisements des lames supérieures et inférieures ;
- les figures 25 à 27 illustrent d'autres variantes de tables de translation ;
- la figure 28 représente, de façon schématisée, et en vue de côté, la partie supérieure et la partie inférieure d'un oscillateur avec un guidage flexible décomposé en deux sous-unités, dans le cas d'espèce un étage supérieur et un étage inférieur, avec une table de translation interposée entre le support fixe et l'appui supérieur des lames supérieures vers l'élément inertiel.

## Description détaillée des modes de réalisation préférés

L'invention concerne un oscillateur mécanique 100 d'horlogerie, comportant au moins un élément support rigide 4 fixé directement ou indirectement sur une platine 900, et un élément inertiel massif 5. Cet oscillateur 100 comporte, entre l'élément support rigide 4 et l'élément inertiel massif 5, un mécanisme de guidage flexible 200. Ce mécanisme de guidage flexible comporte au moins deux premières lames flexibles 31, 32, qui supportent l'élément inertiel massif 5 et sont agencées pour le rappeler vers une position de repos. Cet élément inertiel massif 5 est agencé pour osciller angulairement selon un plan d'oscillation autour de cette position de repos.

Les deux premières lames flexibles 31 et 32 ne se touchent pas, et, en position de repos, leurs projections sur le plan d'oscillation se croisent en un point de croisement P, au voisinage immédiat duquel ou par lequel passe l'axe de rotation de l'élément inertiel massif 5 perpendiculairement au plan d'oscillation. Tous les éléments géométriques décrits ci-après s'entendent, sauf mention contraire, comme étant considérés dans la position de repos de l'oscillateur à l'arrêt.

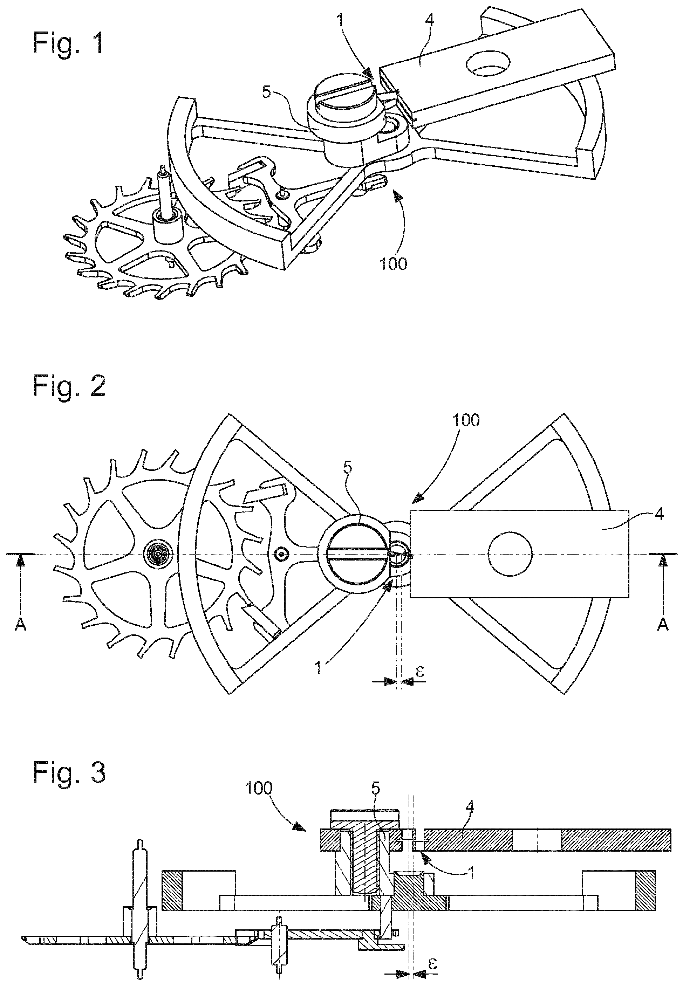

Les figures 1 à 4 illustrent une première variante, qui ne fait pas partie de l'invention, avec un élément support rigide 4 et un élément inertiel massif reliés par deux premières lames flexibles 31, 32.

Les encastrements des premières lames flexibles 31, 32, avec l'élément support rigide 4 et l'élément inertiel massif 5 définissent au moins deux directions de lames DL1, DL2, qui sont parallèles au plan d'oscillation et qui font entre elles, en projection sur le plan d'oscillation, un angle au sommet $\alpha$.

La position du point de croisement P est définie par le rapport X = D/L où D est la distance entre la projection, sur le plan d'oscillation, de l'un des points d'encastrement des premières lames 31, 32, dans le premier élément de support rigide 4 et le point de croisement P, et où L est la longueur totale de la projection, sur le plan d'oscillation, de la lame 31, 32, concernée. Et la valeur du rapport D/L est comprise entre 0 et 1, et l'angle au sommet $\alpha$ est inférieur ou égal à 70°.

De façon avantageuse, à la fois l'angle au sommet $\alpha$ est inférieur ou égal à 60°, et, pour chaque première lame flexible 31, 32, le rapport d'encastrement D1/L1, D2/L2, est compris entre 0.15 et 0.85, bornes comprises.

De façon particulière, tel que visible sur les figures 2 à 4, le centre de masse de l'oscillateur 100 dans sa position de repos est distant du point de croisement P d'un écart $\varepsilon$ qui est compris entre 10% et 20% de la longueur totale L de la projection, sur le plan d'oscillation, de la lame 31, 32. Plus particulièrement encore, l'écart $\varepsilon$ est compris entre 12% et 18% de la longueur totale L de la projection, sur le plan d'oscillation, de la lame 31, 32.

Plus particulièrement, et tel qu'illustré sur les figures, les premières lames 31, 32, et leurs encastrements définissent ensemble un pivot 1 qui, en projection sur le plan d'oscillation, est symétrique par rapport à un axe de symétrie AA passant par le point de croisement P.

Plus particulièrement, quand le pivot 1 est symétrique par rapport à l'axe de symétrie AA, en position de repos, en projection sur le plan d'oscillation, le centre de masse de l'élément inertiel massif 5 est situé sur l'axe de symétrie AA du pivot 1. En projection, ce centre de masse peut être confondu ou non avec le point de croisement P.

Plus particulièrement encore, le centre de masse de l'élément inertiel massif 5 est situé à une distance non nulle du point de croisement P correspondant à l'axe de rotation de l'élément inertiel massif 5, tel que visible sur les figures 2 à 4.

De façon particulière, en projection sur le plan d'oscillation, le centre de masse de l'élément inertiel massif 5 est situé sur l'axe de symétrie AA du pivot 1, et est situé à distance non nulle du point de croisement P laquelle est comprise entre 0.1 fois et 0.2 fois la longueur totale L de la projection, sur le plan d'oscillation, de la lame 31, 32.

Plus particulièrement, les premières lames 31 et 32 sont des lames droites.

Plus particulièrement encore, l'angle au sommet $\alpha$ est inférieur ou égal à 50°, ou encore est inférieur ou égal à 40°, ou encore inférieur ou égal à 35°, ou encore inférieur ou égal à 30°.

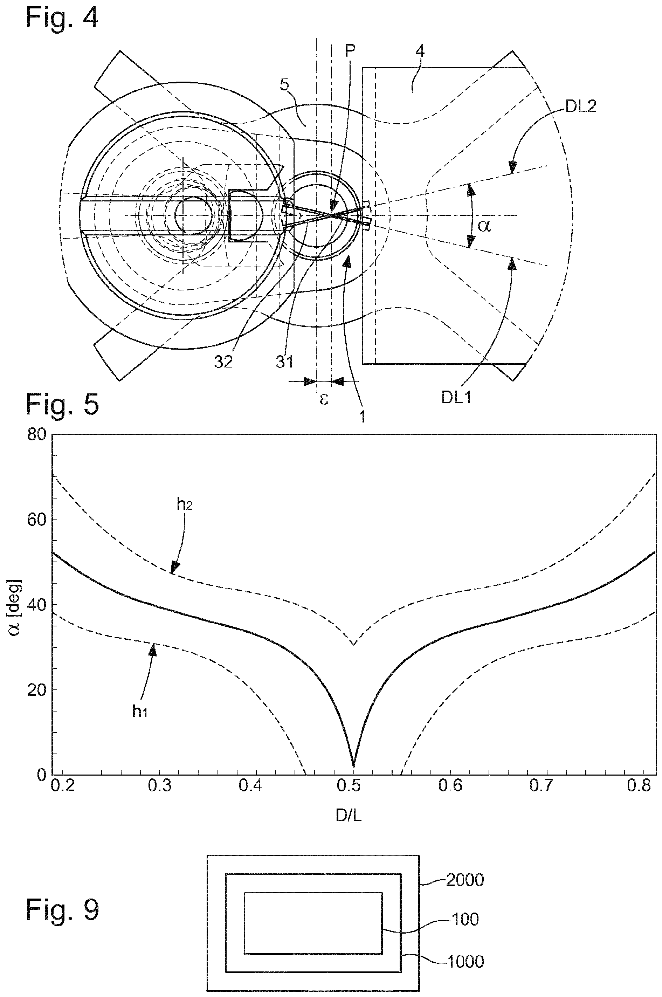

Plus particulièrement, le rapport d'encastrement D1/L1, D2/L2, est compris entre 0.15 et 0.49, bornes comprises, ou entre 0.51 et 0.85, bornes comprises, tel que visible sur la figure 5.

Dans une variante, et plus particulièrement selon l'exécution selon la figure 5, l'angle au sommet $\alpha$ est inférieur ou égal à 50°, et le rapport d'encastrement D1/L1, D2/L2, est compris entre 0.25 et 0.75, bornes comprises.

Dans une variante, et plus particulièrement selon l'exécution selon la figure 5, l'angle au sommet $\alpha$ est inférieur ou égal à 40°, et le rapport d'encastrement D1/L1, D2/L2, est compris entre 0.30 et 0.70, bornes comprises.

Dans une variante, et plus particulièrement selon l'exécution selon la figure 5, l'angle au sommet $\alpha$ est inférieur ou égal à 35°, et le rapport d'encastrement D1/L1, D2/L2, est compris entre 0.40 et 0.60, bornes comprises.

De façon avantageuse, et tel que visible sur la figure 5, l'angle au sommet $\alpha$ et le rapport X= D/L satisfont la relation :

$$h1(D/L) < \alpha < h2(D/L),$$

avec,
pour $0.2 \leq X < 0.5$ :

$$h1(X) = 116 - 473^*(X + 0.05) + 3962^*(X + 0.05)^3 - 6000^*(X + 0.05)^4,$$

$$h2(X) = 128 - 473^*(X - 0.05) + 3962^*(X - 0.05)^3 - 6000^*(X - 0.05)^4,$$

pour

$$0.5 < X \leq 0.8:$$

$$h1(X) = 116 - 473^*(1.05 - X) + 3962^*(1.05 - X)^3 - 6000^*(1.05 - X)^4,$$

$$h2(X) = 128 - 473^*(0.95 - X) + 3962^*(0.95 - X)^3 - 6000^*(0.95 - X)^4.$$

Plus particulièrement, et notamment dans l'exécution non limitative illustrée par les figures, les premières lames flexibles 31 et 32 ont la même longueur L, et la même distance D.

Plus particulièrement, entre leurs encastrements, ces premières lames flexibles 31 et 32 sont identiques.

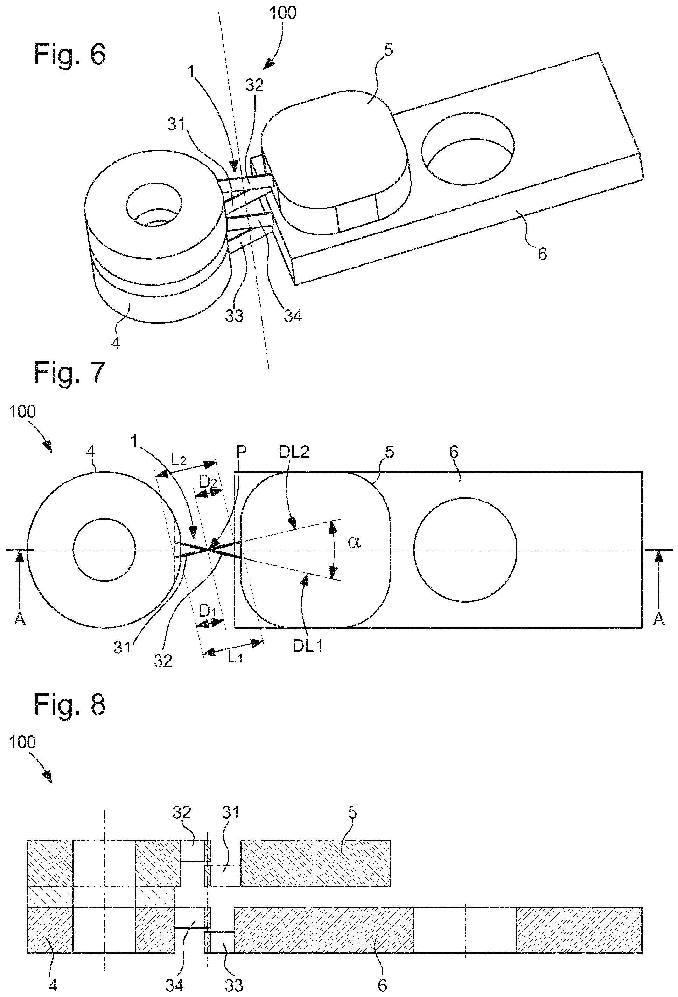

Les figures 6 à 8 illustrent une deuxième variante d'oscillateur mécanique 100, qui ne fait pas partie de l'invention, où l'élément support rigide 4 est aussi mobile, directement ou indirectement par rapport à une structure fixe que comporte cet oscillateur 100, et est porté par un troisième élément rigide 6, par l'intermédiaire de deux secondes lames flexibles 33, 34, agencées de façon similaire au premières lames flexibles 31, 32.

Plus particulièrement, dans la réalisation non limitative illustrée par les figures, les projections des premières lames flexibles 31, 32, et des secondes lames flexibles 33, 34, sur le plan d'oscillation se croisent au même point de croisement P.

Dans une autre forme particulière d'exécution non illustrée, en position de repos, en projection sur le plan d'oscillation, les projections des premières lames flexibles 31, 32, et des secondes lames flexibles 33, 34, sur le plan d'oscillation se croisent en deux points distincts tous deux situés sur l'axe de symétrie AA du pivot 1, quand le pivot 1 est symétrique par rapport à l'axe de symétrie AA.

Plus particulièrement, les encastrements des secondes lames flexibles 33, 34, avec l'élément support rigide 4 et le troisième élément rigide 6, définissent deux directions de lames parallèles au plan d'oscillation et faisant entre elles, en projection sur le plan d'oscillation, un angle au sommet de même bissectrice que l'angle au sommet $\alpha$ que les premières lames flexibles 31, 32. Plus particulièrement encore, ces deux directions des secondes lames flexibles 33, 34, présentent le même angle au sommet $\alpha$ que les premières lames flexibles 31, 32.

Plus particulièrement, les secondes lames flexibles 33, 34, sont identiques aux premières lames flexibles 31, 32, comme dans l'exemple non limitatif des figures.

Plus particulièrement, quand le pivot 1 est symétrique par rapport à l'axe de symétrie AA, en position de repos, en projection sur le plan d'oscillation, le centre de masse de l'élément inertiel massif 5 est situé sur l'axe de symétrie AA du pivot 1.

De façon similaire et particulière, quand le pivot 1 est symétrique par rapport à l'axe de symétrie AA, en position de repos, le centre de masse de l'élément support rigide 4 est situé, en projection sur le plan d'oscillation, sur l'axe de symétrie AA du pivot 1.

Dans une variante particulière, quand le pivot 1 est symétrique par rapport à l'axe de symétrie AA, en position de repos, en projection sur le plan d'oscillation, à la fois le centre de masse du élément inertiel massif 5 et le centre de masse du élément support rigide 4 sont situés sur l'axe de symétrie AA du pivot 1. Plus particulièrement encore, les projections du centre de masse de l'élément inertiel massif 5 et du centre de masse de l'élément support rigide 4, sur l'axe de symétrie AA du pivot 1, sont confondues.

Une configuration particulière illustrée par les figures pour de tels pivots superposés est celle où les projections des premières lames flexibles 31, 32, et des secondes lames flexibles 33, 34, sur le plan d'oscillation se croisent au même point de croisement P, qui correspond aussi à la projection du centre de masse de l'élément inertiel massif 5, ou du moins qui en est la plus proche possible. Plus particulièrement ce même point correspond aussi à la projection du centre de masse de l'élément support rigide 4. Plus particulièrement encore, ce même point correspond aussi à la projection du centre de masse de l'oscillateur 100 tout entier.

Dans une variante particulière de cette configuration de pivots superposés, quand le pivot 1 est symétrique par rapport à l'axe de symétrie AA, en position de repos, en projection sur le plan d'oscillation, le centre de masse de l'élément inertiel massif 5 est situé sur l'axe de symétrie AA du pivot 1, et à une distance non nulle du point de croisement correspondant à l'axe de rotation de l'élément inertiel massif 5, laquelle distance non nulle est comprise entre 0.1 fois et 0.2 fois la longueur totale L de la projection, sur le plan d'oscillation, de la lame 33, 34, avec un écart similaire à l'écart $\varepsilon$ des figures 2 à 4.

De façon similaire et particulière, quand le pivot 1 est symétrique par rapport à l'axe de symétrie AA, le centre de masse de l'élément inertiel massif 5 est situé, en projection sur le plan d'oscillation, sur l'axe de symétrie AA du pivot 1 et à une distance non nulle du point de croisement correspondant à l'axe de rotation de l'élément support rigide 4 laquelle distance non nulle est comprise entre 0.1 fois et 0.2 fois la longueur totale L de la projection, sur le plan d'oscillation, de la lame 31, 32.

De façon similaire et particulière, quand le pivot 1 est symétrique par rapport à l'axe de symétrie AA, le centre de masse de l'élément support rigide 4 est situé, en projection sur le plan d'oscillation, sur l'axe de symétrie AA du pivot 1 et à une distance non nulle du point de croisement P correspondant à l'axe de rotation de l'élément inertiel massif 5. Notamment cette distance non nulle est comprise entre 0.1 fois et 0.2 fois la longueur totale L de la projection, sur le plan d'oscillation, de la lame 33, 34.

De façon similaire et particulière, quand le pivot 1 est symétrique par rapport à l'axe de symétrie AA, le centre de masse de l'élément support rigide 4 est situé, en projection sur le plan d'oscillation, sur l'axe de symétrie AA du pivot 1 et à une distance non nulle du point de croisement correspondant à l'axe de rotation de l'élément support rigide 4 laquelle distance non nulle est comprise entre 0.1 fois et 0.2 fois la longueur totale L de la projection, sur le plan d'oscillation, de la lame 31, 32.

De façon similaire et particulière, le centre de masse de l'élément support rigide 4 est situé sur l'axe de symétrie AA du pivot 1 et à la distance non nulle du point de croisement P laquelle est comprise entre 0.1 fois et 0.2 fois la longueur totale L de la projection, sur le plan d'oscillation, de la lame 33, 34.

Plus particulièrement, et tel que visible sur la variante des figures, quand le pivot 1 est symétrique par rapport à l'axe de symétrie AA, en projection sur le plan d'oscillation, le centre de masse de l'oscillateur 100 dans sa position de repos est situé sur l'axe de symétrie AA.

Plus particulièrement, l'élément inertiel massif 5 est allongé selon la direction de l'axe de symétrie AA du pivot 1, quand le pivot 1 est symétrique par rapport à l'axe de symétrie AA. C'est par exemple le cas des figures 1 à 4 où l'élément inertiel 5 comporte une embase sur laquelle est fixé un balancier traditionnel à bras longs pourvus de tronçons de serge ou de masselottes en arc de cercle. L'objectif est de minimiser l'influence des accélérations angulaires externes autour de l'axe de symétrie du pivot, car les lames ont une faible rigidité en rotation autour de cet axe à cause du petit angle $\alpha$.

L'invention se prête bien à une exécution monolithique des lames et des composants massifs qu'elles joignent, en matériau micro-usinable ou au moins partiellement amorphe, avec une mise en oeuvre par procédé « MEMS » ou « LIGA » ou similaire. En particulier, dans le cas d'une exécution en silicium, l'oscillateur 100 est avantageusement compensé thermiquement par ajout de dioxyde de silicium sur des lames flexibles en silicium. Dans une variante, les lames peuvent être assemblées, par exemple encastrées dans des rainures, ou autre.

Lorsque on a deux pivots en série, comme dans le cas de figures 6 à 9, on peut mettre le centre de masse sur l'axe de rotation, dans le cas où l'agencement est choisi pour que les déplacements parasites se compensent, ce qui constitue une variante avantageuse mais non limitative. Il convient toutefois de remarquer qu'il n'est pas nécessaire de choisir un tel agencement, et un tel oscillateur fonctionne avec deux pivots en série sans pour autant positionner le centre de masse sur l'axe de rotation. Bien sûr, même si les réalisations illustrées correspondent à des configurations géométriques particulières d'alignement, ou de symétrie, on comprend qu'il est aussi possible d'empiler deux pivots différents, ou avec des points de croisement différents, ou avec des centres de masses non alignés, ou encore de mettre en oeuvre un nombre supérieur de jeux de lames en série, avec des masses intermédiaires, pour augmenter encore l'amplitude du balancier.

Les variantes illustrées comportent tous les axes de pivotement, croisements de lames, et centres de masse, coplanaires, ce qui est un cas particulier avantageux, mais non limitatif.

On comprend qu'il est ainsi possible d'obtenir une course angulaire qui est grande: en tous les cas supérieure à 30°, elle peut même atteindre 50° voire 60°, ce qui la rend compatible en combinaison avec tous les échappements mécaniques usuels, ancre suisse, détente, co-axial, ou autre.

Il s'agit, encore, de déterminer une solution pratique qui soit équivalente à l'utilisation théorique d'une grande valeur du rapport d'aspect des lames.

A cet effet, il est avantageux de subdiviser les lames dans le sens de la longueur, en substituant à une lame unique une pluralité de lames élémentaires dont le comportement global soit équivalent, et où chacune des lames élémentaires a un rapport d'aspect limité à une valeur seuil. On diminue ainsi, par rapport à une lame unique de référence, le rapport d'aspect de chaque lame élémentaire, pour retrouver l'optimum d'isochronisme et d'insensibilité aux positions.

Chaque lame 31, 32, a un rapport d'aspect RA = H/E, où H est la hauteur de la lame 31,32, perpendiculairement à la fois au plan d'oscillation et à l'élongation de la lame 31, 32, selon la longueur L, et où E est l'épaisseur de la lame 31, 32, dans le plan d'oscillation et perpendiculairement à l'élongation de la lame 31, 32, selon la longueur L.

De façon préférée, le rapport d'aspect RA = H/E est inférieur à 10 pour chaque lame 31, 32. Plus particulièrement ce rapport d'aspect est inférieur à 8. Et le nombre total des lames flexibles 31, 32, est strictement supérieur à deux.

Plus particulièrement, l'oscillateur 100 comporte un premier nombre N1 de premières lames appelées lames primaires 31 s'étendant selon une première direction de lame DL1, et un deuxième nombre N2 de premières lames secondaires 32 s'étendant selon une deuxième direction de lame DL2, le premier nombre N1 et le deuxième nombre N2 étant chacun supérieur ou égal à deux.

Plus particulièrement, le premier nombre N1 est égal au deuxième nombre N2.

Plus particulièrement encore, l'oscillateur 100 comporte au moins une paire formée d'une lame primaire 31 s'étendant selon une première direction de lame DL1, et d'une lame secondaire 32 s'étendant selon une deuxième direction de lame DL2. Et, dans chaque paire, la lame primaire 31 est identique à la lame secondaire 32 à l'orientation près.

Dans une variante particulière, l'oscillateur 100 ne comporte que des paires chacune formée d'une lame primaire 31 s'étendant selon une première direction de lame DL1, et d'une lame secondaire 32 s'étendant selon une deuxième direction de lame DL2, et, dans chaque paire, la lame primaire 31 est identique à la lame secondaire 32 à l'orientation près.

Dans une autre variante, l'oscillateur 100 comporte au moins un groupe de lames formé d'une lame primaire 31 s'étendant selon une première direction de lame DL1, et d'une pluralité de lames secondaires 32 s'étendant selon une deuxième direction de lame DL2. Et, dans ce cas, dans chaque groupe de lames, le comportement élastique de la lame primaire 31 est identique au comportement élastique résultant du cumul de la pluralité de lames secondaires 32 à l'orientation près.

On remarque encore que, si le comportement d'une lame flexible dépend de son rapport d'aspect RA, il dépend également de la valeur de la courbure qui lui est imprimée. Sa déformée dépend à la fois de la valeur du rapport d'aspect et de la valeur locale du rayon de courbure, notamment à l'encastrement. C'est la raison pour laquelle on adopte, de préférence, une disposition des lames en symétrie en projection plane.

L'invention concerne encore un mouvement d'horlogerie 1000 comportant au moins un tel oscillateur 100 mécanique.

L'invention concerne encore une montre 2000 comportant au moins un tel mouvement d'horlogerie 1000.

Un procédé de fabrication convenable consiste à effectuer, pour les différents types de pivots ci-dessous, les opérations suivantes :

Pour un type de pivot AABB :

    a. utiliser un substrat avec au moins quatre couches, résultant par exemple mais non limitativement de l'assemblage de deux wafers SOI ;

    b. graver par procédé de gravure "DRIE" face avant pour obtenir AA, avec notamment gravure des deux couches d'un seul tenant ;

c. graver par procédé de gravure "DRIE" face arrière pour obtenir BB, avec notamment gravure des deux couches d'un seul tenant ;

d. effectuer la séparation partielle des quatre couches par gravure de l'oxyde enterré.

La grande précision du procédé "DRIE", c'est-à-dire gravure ionique réactive profonde (en anglais Deep Reactive Ion Etching DRIE) garantit une très bonne précision en positionnement et en alignement, inférieure ou égale à 5 micromètres, grâce à un alignement optique, ce qui garantit un très bon alignement face à face. Naturellement des procédés équivalents peuvent être mis en oeuvre selon le matériau choisi.

Il est possible de mettre en oeuvre des substrats avec un nombre supérieur de couches, notamment un substrat à six couches disponibles, par exemple par assemblage de deux DSOI, pour obtenir une structure de type AAABBB.

Une variante pour l'obtention d'un même type de pivot AABB consiste à :

a. utiliser deux substrats SOI standard à deux couches ;

b. graver par procédé de gravure "DRIE" le premier substrat, sur la face avant pour obtenir A, sur la face arrière pour obtenir A ;

c. graver par procédé de gravure "DRIE" le deuxième substrat, sur la face avant pour obtenir B, sur la face arrière pour obtenir B ; en alternative des opérations b et c on peut, sur le premier substrat et sur le deuxième substrat effectuer la gravure outre des deux couches en une fois, sans effectuer une gravure face avant et face arrière ;

d. effectuer l'assemblage « wafer à wafer » des deux substrats ou « pièce à pièce » des composants individuels, pour obtenir AABB. Le bon alignement des géométries est alors lié à la spécification de la machine de bonding « wafer à wafer » ou au process « pièce à pièce », de façon bien connue de l'homme du métier.

Pour un type de pivot ABAB :

a. utiliser deux substrats SOI standard à deux couches ;

b. graver par procédé de gravure "DRIE" le premier substrat, sur la face avant pour obtenir A, sur la face arrière pour obtenir B ;

c. graver par procédé de gravure "DRIE" le deuxième substrat, sur la face avant pour obtenir A, sur la face arrière pour obtenir B ;

d. effectuer l'assemblage « wafer à wafer » des deux substrats ou « pièce à pièce » des composants individuels, pour obtenir ABAB. Comme précédemment, Le bon alignement des géométries est lié à la spécification de la machine de bonding « wafer à wafer » ou au process « pièce à pièce ».

Bien d'autres variantes de procédé peuvent être mises en oeuvre, selon le nombre de lames et l'équipement disponible.

Les méthodes standard de fabrication par gravure DRIE du silicium ne permettent pas encore de fabriquer facilement un pivot monolithique ayant plus de deux niveaux distincts. Il est donc plus facile fabriquer des pièces séparées qui sont ensuite assemblées. Toutefois, la sensibilité aux erreurs d'assemblage nécessite une précision supérieure au micromètre, pour obtenir les propriétés optimales d'isochronisme et/ou d'insensibilité aux positions. Afin de résoudre ce problème, il est nécessaire d'adopter une stratégie de fabrication qui est décrite ci-dessous.

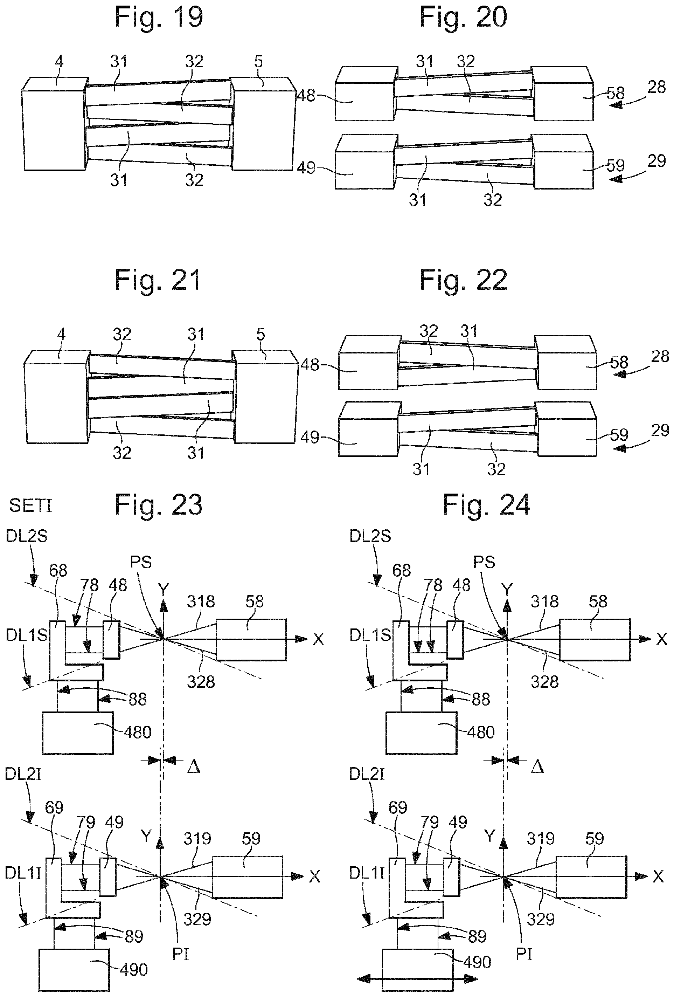

Dans une première démarche, il s'agit d'assembler avec une grande précision deux lames ayant des directions différentes. L'invention se propose de diviser le guidage flexible, ou pivot, en sous-unités composées de pivots à deux lames, par exemple une sous-unité supérieure et une sous-unité inférieure, dans le cas d'un guidage flexible comportant quatre lames, tel que visible sur la figure 19, avec quatre lames alternées, que l'on décompose en deux sous-unités de pivots à deux lames. Les figures 21 et 22 illustrent une décomposition similaire dans le cas de lames encadrées plutôt que de lames alternées. Chaque sous-unité est fabriquée par gravure DRIE à deux niveaux (wafer SOI attaqué par dessus et par dessous) afin de garantir une précision d'alignement suffisante.

La sous-unité supérieure est ensuite assemblée à la sous-unité inférieure.

Cet assemblage peut être effectué par toute méthode traditionnelle: goupillage d'alignement et vissage, ou collage, ou « wafer fusion bonding », ou soudure, ou brasure, ou toute autre méthode connue de l'homme du métier.

Le défaut d'assemblage se manifeste par un petit décalage $\Delta$ des axes de rotation des sous-unités supérieure et inférieure. De sorte que le mouvement de rotation du résonateur dicté par la sous-unité supérieure n'est pas en accord avec le mouvement de rotation dicté par la sous-unité inférieure.

Pour éviter que ce décalage ne produise une sur-contrainte, le mécanisme comporte au moins une table de translation, dont le mouvement libre permet d'absorber le désaccord entre les deux rotations d'axes distincts. Au moins une des tables de translation doit être suffisamment souple pour que le désaccord de mouvement ne dégrade pas l'isochronisme. Dans le cas où l'on introduit deux tables de translation identiques, comme représenté dans la figure 23, elles doivent être suffisamment souples pour que le désaccord de mouvement ne dégrade pas l'isochronisme, et suffisamment rigides pour que la position du pivot soit bien déterminée. Les calculs montrent que ces conditions ne sont pas contradictoires si le décalage entre les axes de rotation est inférieur à 10 micromètres, ce qui est réalisable par assemblage traditionnel. Naturellement la précision d'un tel assemblage peut être améliorée avec des gravures complémentaires, de type tenon-mortaise, ou avec une pluralité d'assemblages tenon-mortaise faisant entre eux un angle non nul, ou tout autre agencement connu en mécanique de précision.

Plus particulièrement, tel que visible sur les figures, le mécanisme de guidage flexible 200 comporte, superposés l'un sur l'autre, au moins un étage supérieur 28 et au moins un étage inférieur 29.

La sous-unité supérieure comporte un étage supérieur 28, qui comporte, entre un support supérieur 48 et un élément inertiel supérieur 58, au moins une lame primaire supérieure 318 s'étendant selon une première direction de lame supérieure DL1S et une lame secondaire supérieure 328 s'étendant selon une deuxième direction de lame supérieure DL2S, croisées en projection en un point de croisement supérieur PS.

La sous-unité inférieure comporte un étage inférieur 29, qui comporte, entre un support inférieur 49 et un élément inertiel inférieur 59, au moins une lame primaire inférieure 319 s'étendant selon une première direction de lame inférieure DL1I et une lame secondaire inférieure 329 s'étendant selon une deuxième direction de lame inférieure DL2I croisées en projection en un point de croisement inférieur PI, distant au repos du point de croisement supérieur PS d'un écart Δ.

Et au moins l'étage supérieur 28 ou l'étage inférieur 29 comporte, entre la platine 900 et le support supérieur 48, ou respectivement le support inférieur 49, une table de translation supérieure 308, ou respectivement une table de translation inférieure 309, qui comporte au moins une liaison élastique qui autorise la translation selon un ou deux axes de liberté dans le plan d'oscillation, et dont la raideur en translation selon ces deux axes est inférieure à celle de chaque lame flexible 31, 32, 333, 34, 318, 319, 328, 329, que comporte le mécanisme de guidage flexible 200.

Notons que cette liaison élastique n'autorise pas les rotations d'axe parallèle à celui du résonateur.

On notera qu'il n'est pas nécessaire que les directions supérieures DL1S et DL2S de l'étage supérieur 28 soient identiques aux directions inférieures DL1I et DL2I de l'étage inférieur 29. De préférence, elles possèdent les mêmes bissectrices.

Plus particulièrement, le point P par lequel passe l'axe de rotation de l'élément inertiel 5 est situé entre le point de croisement supérieur PS et le point de croisement inférieur PI, exactement au milieu si le mécanisme de guidage flexible 200 comporte deux tables de translations supérieure 308 et inférieure 309 qui sont identiques. Dans une variante, ce point P est situé exactement sur le point de croisement inférieur PI si l'étage inférieur 29 ne possède pas de table de translation, ou sur le point de croisement supérieur PS si l'étage supérieur 28 ne possède pas de table de translation.

De préférence, l'oscillateur 100 comporte, pour chaque mécanisme de guidage flexible 200 qu'il comporte, un élément inertiel massif 5 est unique. Plus particulièrement, le mécanisme de guidage flexible 200 est unique, et l'élément inertiel massif 5 est unique.

Naturellement, la configuration préférée des tables de translation 308 et 309 illustrée par les figures n'est pas limitative.

Selon l'invention telle que définie dans la revendication indépendante 2 annexée, ces tables de translation 308 et 309 se trouvent entre l'élément inertiel 5 et les encastrements du côté élément inertiel.

Si l'on définit par X et Y les axes des bissectrices des angles que font entre elles les projections des lames flexibles sur un plan parallèle commun, la combinaison des tables en translation, selon l'axe X et selon l'axe Y, doit être plus souple que le pivot flexible selon les mêmes axes. Cette règle est valable quel que soit le nombre d'étages, le cumul dû à la combinaison de toutes les tables, en translation, selon l'axe X et selon l'axe Y, doit être plus souple que le pivot flexible. La liaison élastique de la table de translation supérieure 308, et respectivement de la table de translation inférieure 309, selon un ou deux axes de liberté dans le plan d'oscillation, est ainsi de préférence une liaison élastique selon ces axes X et Y.

Le stockage supplémentaire d'énergie élastique dans la ou les tables de translation, qui résulte du désaccord de mouvement, s'ajoute au stockage principal d'énergie du pivot, et tend à perturber l'isochronisme, sauf si la valeur du stockage supplémentaire est très inférieure à celle du stockage principal. C'est pourquoi les liaisons élastiques dans les tables de translation doivent être beaucoup plus souples que celles du pivot flexible.

Selon l'invention, l'étage supérieur 28 et l'étage inférieur 29 comportent chacun, entre la platine 900 et le support supérieur 48, et respectivement le support inférieur 49, une table de translation supérieure 308, et respectivement une table de translation inférieure 309, comportant au moins une liaison élastique selon un ou deux axes de liberté dans le plan d'oscillation, et dont la raideur est inférieure à celle de chaque lame flexible.

Les tables de translation ne sont pas nécessairement identiques entre elles.

Une variante consiste à utiliser deux tables de translation différentes, la première étant souple afin que le désaccord de mouvement ne dégrade pas l'isochronisme, et la seconde étant rigide afin d'assurer le positionnement du pivot.

Dans une autre variante, un étage peut comporter une table de translation, et l'autre étage avoir une fixation rigide

L'élément inertiel supérieur 58 et l'élément inertiel inférieur 59 constituent tout ou partie de l'élément inertiel massif 5, et sont rigidement liés, directement ou indirectement, entre eux. Le support supérieur 48 et le support inférieur 49 sont quant à eux, liés, selon le cas directement ou au travers d'une table de translation supérieure 308, ou respectivement une table de translation inférieure 309, à une partie rigide supérieure 480, respectivement une partie rigide inférieure 490, qui elles sont rigidement liées à l'élément support rigide 4, ou à la platine 900.

Les figures 23 et 24 montrent un exemple d'une telle liaison. Une table de translation supérieure 308 comporte, entre le support supérieur 48 et une masse intermédiaire supérieure 68, des premières liaisons élastiques souples 78 s'étendant selon la direction X, et, entre la masse intermédiaire supérieure 68 et la partie rigide supérieure 480, des deuxièmes liaisons élastiques souples 88 s'étendant selon la direction Y. De la même façon, une table de translation inférieure 309 comporte, entre le support inférieur 49 et une masse intermédiaire inférieure 69, des premières liaisons élastiques souples 79 s'étendant selon la direction X, et, entre la masse intermédiaire inférieure 69 et la partie rigide inférieure 490, des deuxièmes liaisons élastiques souples 89 s'étendant selon la direction Y.

Ainsi, le mouvement des tables de translation, permet d'absorber le désaccord éventuel entre les rotations de la sous-unité supérieure et de la sous-unité inférieure. De plus, Chaque table de translation participe à la protection du mécanisme contre les fortes accélérations, lors d'une chute ou percussion par exemple.

On comprend que l'assemblage tel que décrit ci-dessus dans le cadre de la première démarche permet de rendre négligeable l'anisochronisme ajouté, à condition que le défaut d'assemblage Δ soit suffisamment petit.

A contrario, on peut décider d'exagérer volontairement le défaut d'assemblage Δ, afin d'introduire de l'anisochronisme de façon contrôlée, par exemple pour compenser un retard à l'échappement. Il est alors avantageux de rendre mobile, et réglable, au moins l'un des encastrements à la platine, c'est-à-dire le support supérieur 48 et/ou le support inférieur 49 dans le cas de la variante particulière non limitative illustrée. En effet, en ajustant la position relative de ces deux encastrements, on modifie la rigidité des tables de translation 308, 309, ce qui a pour effet de permettre le réglage de l'anisochronisme ajouté. Un tel réglage peut être effectué facilement avec la combinaison d'une gorge et d'un excentrique, ou par toute autre solution connue de l'horloger.

En somme, en déplaçant la position d'au moins un des encastrements à la platine, tel que visible sur la figure 24, il est possible d'ajuster l'anisochronisme produit par le défaut d'assemblage Δ.

Cet agencement particulier avec au moins une table de translation permet, en somme, de garantir l'alignement entre les étages supérieur et inférieur, et d'éviter les grandes contraintes que subiraient les lames si les étages supérieur et inférieur ne suivaient pas la même trajectoire.

Une autre alternative encore consiste à équiper le mécanisme avec une table de translation supérieure 308 et d'une table de translation inférieure 309, avec un support supérieur 48 et un support inférieur 49 qui ne sont plus rigidement liés à l'élément support rigide 4, ou à la platine 900, mais qui sont contraints à des mouvements plans, inverses en X et en Y, par une liaison de type vilebrequin ou similaire, par rapport à un axe fixe de l'élément support rigide 4, ou de la platine 900. Cette solution a l'avantage de permettre d'ajuster l'anisochronisme sans pour autant déplacer légèrement l'axe de rotation du résonateur.

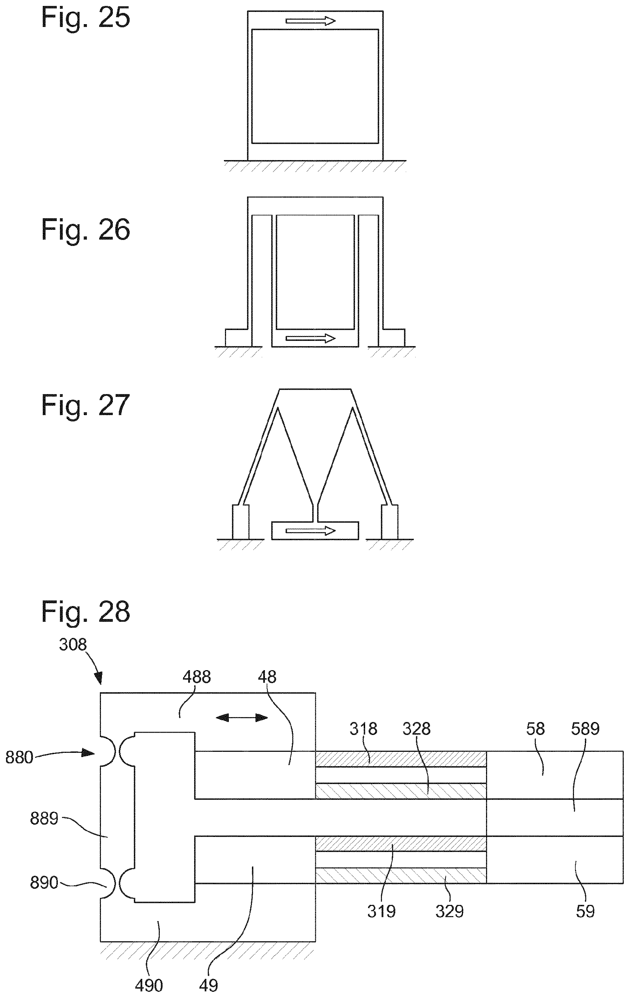

On comprend que les tables de translation, qui constituent des guidages flexibles en translation, peuvent être réalisées de bien des manières différentes. L'homme du métier en trouvera des exemples dans les références suivantes : [1] S.Henein, Conception des guidages flexibles. PPUR, [2] Larry L. Howell, Handbook of compliant mechanisms, WILEY), ou encore [3] Zeyi Wu and Qingsong Xu, Actuators 2018. De tels exemples non limitatifs sont illustrés aux figures 25 à 27.

La figure 28 illustre un exemple simplifié avec une table de translation avec liaison par cols : le support supérieur 48 est lié à un élément intermédiaire 488 suspendu par un premier col élastique 880 à un deuxième élément intermédiaire 889 à un deuxième col 890 qui effectue la liaison élastique avec la partie rigide inférieure 490, rigidement liée à la platine 900. Dans cet exemple l'élément inertiel supérieur 58 et l'élément inertiel inférieur 59 sont liés à un autre élément intermédiaire 589 pour constituer avec lui l'élément inertiel massif 5.

## Revendications

**1.** Oscillateur mécanique (100) d'horlogerie, comportant, entre un élément support rigide (4) fixé directement ou indirectement sur une platine (900), et un élément inertiel massif (5), un mécanisme de guidage flexible (200) comportant au moins deux premières lames flexibles (31 ; 32) qui supportent ledit élément inertiel massif (5) et sont agencées pour le rappeler vers une position de repos, ledit élément inertiel massif (5) étant agencé pour osciller angulairement selon un plan d'oscillation autour de ladite position de repos, lesdites deux premières lames flexibles (31 ; 32) ne se touchant pas et leurs projections sur ledit plan d'oscillation se croisant, en position de repos, en un point de croisement (P), au voisinage duquel passe l'axe de rotation dudit élément inertiel massif (5) perpendiculairement audit plan d'oscillation, **caractérisé en ce que** ledit mécanisme de guidage flexible (200) comporte, superposés l'un sur l'autre, au moins un étage supérieur (28) qui comporte, entre un support supérieur (48) et ledit élément inertiel massif (5) au moins une lame primaire supérieure (318) s'étendant selon une première direction de lame supérieure

(DL1S) et une lame secondaire supérieure (328) s'étendant selon une deuxième direction de lame supérieure (DL2S) croisées en projection en un point de croisement supérieur (PS) définissant un pivot supérieur, et au moins un étage inférieur (29) définissant un pivot inférieur et qui comporte, entre un support inférieur (49) et ledit élément inertiel massif (5) au moins une lame primaire inférieure (319) s'étendant selon une première direction de lame inférieure (DL1I) et une lame secondaire inférieure (329) s'étendant selon une deuxième direction de lame inférieure (DL2I) croisées en projection en un point de croisement inférieur (PI), les lames primaires (318, 319) et secondaires (328, 329) définissant les premières lames flexibles (31 ; 32) du mécanisme de guidage flexible (200), **caractérisé en ce que** ledit étage supérieur (28) et ledit étage inférieur (29) comportent chacun, entre ladite platine (900) et ledit support supérieur (48), et respectivement ledit support inférieur (49), une table de translation (308 ; 309) comportant au moins une liaison élastique selon un ou deux axes de liberté dans le plan d'oscillation, et dont la raideur en translation est inférieure à celle dudit pivot de l'étage supérieur et aussi à celle dudit pivot de l'étage inférieur, pour permettre une translation relative entre ledit étage supérieur et ledit étage inférieur, de façon à permettre l'ajustement de la position relative des deux encastrements desdites lames flexibles (31 ; 32) du côté du support supérieur (48) et du support inférieur (49), et la modification de la rigidité desdites tables de translation (308 ; 309) pour permettre le réglage de l'anisochronisme.

2.  Oscillateur mécanique (100) d'horlogerie, comportant, entre un élément support rigide (4) fixé directement ou indirectement sur une platine (900), et un élément inertiel massif (5), un mécanisme de guidage flexible (200) comportant au moins deux premières lames flexibles (31 ; 32) qui supportent ledit élément inertiel massif (5) et sont agencées pour le rappeler vers une position de repos, ledit élément inertiel massif (5) étant agencé pour osciller angulairement selon un plan d'oscillation autour de ladite position de repos, lesdites deux premières lames flexibles (31 ; 32) ne se touchant pas et leurs projections sur ledit plan d'oscillation se croisant, en position de repos, en un point de croisement (P), au voisinage duquel passe l'axe de rotation dudit élément inertiel massif (5) perpendiculairement audit plan d'oscillation, **caractérisé en ce que** ledit mécanisme de guidage flexible (200) comporte, superposés l'un sur l'autre, au moins un étage supérieur (28) qui comporte, entre un support supérieur (48) et ledit élément inertiel massif (5) au moins une lame primaire supérieure (318) s'étendant selon une première direction de lame supérieure (DL1S) et une lame secondaire supérieure (328) s'étendant selon une deuxième direction de lame supérieure (DL2S) croisées en projection en un point de croisement supérieur (PS) définissant un pivot supérieur, et au moins un étage inférieur (29) définissant un pivot inférieur et qui comporte, entre un support inférieur (49) et ledit élément inertiel massif (5) au moins une lame primaire inférieure (319) s'étendant selon une première direction de lame inférieure (DL1I) et une lame secondaire inférieure (329) s'étendant selon une deuxième direction de lame inférieure (DL2I) croisées en projection en un point de croisement inférieur (PI), les lames primaires (318, 319) et secondaires (328, 329) définissant les premières lames flexibles (31 ; 32) du mécanisme de guidage flexible (200), **caractérisé en ce qu'**il comprend, entre l'élément inertiel (5) et l'encastrement de la lame primaire inférieure (319), et respectivement, entre l'élément inertiel (5) et l'encastrement de la lame secondaire inférieure (329), une table de translation (308 ; 309) comportant au moins une liaison élastique selon un ou deux axes de liberté dans le plan d'oscillation, et dont la raideur en translation est inférieure à celle dudit pivot de l'étage supérieur et aussi à celle dudit pivot de l'étage inférieur, pour permettre une translation relative entre ledit étage supérieur et ledit étage inférieur, de façon à permettre l'ajustement de la position relative des deux encastrements desdites lames flexibles (31 ; 32) du côté dudit élément inertiel massif (5), et la modification de la rigidité desdites tables de translation (308 ; 309) pour permettre le réglage de l'anisochronisme.

3.  Oscillateur mécanique (100) selon la revendication 1 ou 2, **caractérisé en ce que** ladite liaison élastique de ladite table de translation supérieure (308), ou respectivement de ladite table de translation inférieure (309), selon un ou deux axes de liberté dans ledit plan d'oscillation, est une liaison élastique selon les axes X et Y des bissectrices des angles que font entre elles les projections des lames flexibles dudit mécanisme de guidage flexible (200) sur un plan parallèle commun.

4.  Oscillateur mécanique (100) selon l'une des revendications 1 à 3, **caractérisé en ce que** lesdites deux directions de lames (DL1 ; DL2) parallèles audit plan d'oscillation et faisant entre elles, en position de repos, en projection sur ledit plan d'oscillation, un angle au sommet $\alpha$, la position dudit point de croisement (P) étant définie par le rapport X= D/L où D est la distance entre la projection, sur ledit plan d'oscillation, de l'un des points d'encastrement desdites premières lames (31 ; 32) dans ledit premier élément de support rigide (4) et ledit point de croisement (P), et où L est la longueur totale de la projection, sur ledit plan d'oscillation, de ladite lame (31 ; 32), et **en ce que** le centre de masse dudit oscillateur (100) dans sa position de repos est distant dudit point de croisement (P) d'un écart ($\varepsilon$) qui est compris entre 12% et 18% de ladite longueur totale L de la projection, sur ledit plan d'oscillation, de ladite lame (31 ; 32), **en ce que** la valeur dudit rapport D/L est comprise entre 0 et 1, **en ce que** ledit angle au sommet ($\alpha$) est inférieur ou égal à 60°, et **en ce que**, pour chaque dite première lame flexible (31 ; 32), le rapport d'encastrement (D1/L1 ; D2/L2) est compris entre 0.15 et 0.85, bornes comprises.

5. Oscillateur mécanique (100) selon l'une des revendications 1 à 3, **caractérisé en ce que** chaque dite lame (31 ; 32) a un rapport d'aspect RA = H/E, où H est la hauteur de ladite lame (31 ; 32) perpendiculairement à la fois au plan d'oscillation et à l'élongation de ladite lame (31 ; 32) selon ladite longueur L, et où E est l'épaisseur de ladite lame (31 ; 32) dans le plan d'oscillation et perpendiculairement à l'élongation de ladite lame (31 ; 32) selon ladite longueur L, et **en ce que** ledit rapport d'aspect RA = H/E est inférieur à 10 pour chaque dite lame (31 ; 32), et **en ce que** le nombre total desdites lames flexibles (31 ; 32) est strictement supérieur à deux.

6. Oscillateur mécanique (100) selon la revendication 5, **caractérisé en ce que** ledit oscillateur (100) comporte un premier nombre N1 de dites premières lames appelées lames primaires (31) s'étendant selon une première direction de lame (DL1), et un deuxième nombre N2 de dites premières lames dites lames secondaires (32) s'étendant selon une deuxième direction de lame (DL2), ledit premier nombre N1 et ledit deuxième nombre N2 étant chacun supérieur ou égal à deux.

7. Oscillateur mécanique (100) selon la revendication 6, **caractérisé en ce que** ledit premier nombre N1 est égal audit deuxième nombre N2.

8. Oscillateur mécanique (100) selon la revendication 6 ou 7, **caractérisé en ce que** ledit oscillateur comporte au moins une paire formée d'une dite lame primaire (31) s'étendant selon une première direction de lame (DL1), et d'une dite lame secondaire (32) s'étendant selon une deuxième direction de lame (DL2), et **en ce que**, dans chaque paire, ladite lame primaire (31) est identique à ladite lame secondaire (32) à l'orientation près.

9. Oscillateur mécanique (100) selon la revendication 8, **caractérisé en ce que** ledit oscillateur ne comporte que des dites paires chacune formée d'une dite lame primaire (31) s'étendant selon une première direction de lame (DL1), et d'une dite lame secondaire (32) s'étendant selon une deuxième direction de lame (DL2), et **en ce que**, dans chaque paire, ladite lame primaire (31) est identique à ladite lame secondaire (32) à l'orientation près.

10. Oscillateur mécanique (100) selon la revendication 6 ou 8 selon 6, **caractérisé en ce que** ledit oscillateur comporte au moins un groupe de lames formé d'une dite lame primaire (31) s'étendant selon une première direction de lame (DL1), et d'une pluralité de dite lames secondaires (32) s'étendant selon une deuxième direction de lame (DL2), et **en ce que**, dans chaque dit groupe de lames, le comportement élastique de ladite lame primaire (31) est identique au comportement élastique résultant de ladite pluralité de lames secondaires (32) à l'orientation près.

11. Oscillateur mécanique (100) d'horlogerie, selon l'une des revendications 1 à 10, **caractérisé en ce que** lesdites deux directions de lames (DL1 ; DL2) parallèles audit plan d'oscillation font entre elles, en position de repos, en projection sur ledit plan d'oscillation, un angle au sommet $\alpha$, la position dudit point de croisement (P) étant définie par le rapport X= D/L, où D est la distance entre la projection, sur ledit plan d'oscillation, de l'un des points d'encastrement desdites premières lames (31 ; 32) dans ledit premier élément de support rigide (4) et ledit point de croisement (P), et L est la longueur totale de la projection, sur ledit plan d'oscillation, de ladite lame (31 ; 32) dans son élongation, et **en ce que** ledit rapport d'encastrement (D1/L1 ; D2/L2) est compris entre 0.15 et 0.49, bornes comprises, ou entre 0.51 et 0.85, bornes comprises.

12. Oscillateur mécanique (100) selon la revendication 11, **caractérisé en ce que** ledit angle au sommet ($\alpha$) est inférieur ou égal à 50°, et **caractérisé en ce que** ledit rapport d'encastrement (D1/L1 ; D2/L2) est compris entre 0.25 et 0.75, bornes comprises.

13. Oscillateur mécanique (100) selon la revendication 12, **caractérisé en ce que** ledit angle au sommet ($\alpha$) est inférieur ou égal à 40°, **en ce que** ledit rapport d'encastrement (D1/L1 ; D2/L2) est compris entre 0.30 et 0.70, bornes comprises.

14. Oscillateur mécanique (100) selon la revendication 13, **caractérisé en ce que** ledit angle au sommet ($\alpha$) est inférieur ou égal à 35°, **en ce que** ledit rapport d'encastrement (D1/L1 ; D2/L2) est compris entre 0.40 et 0.60, bornes comprises.

15. Oscillateur mécanique (100) selon l'une des revendications 11 à 14, **caractérisé en ce que** ledit angle au sommet ($\alpha$) est inférieur ou égal à 30°.

**16.** Oscillateur mécanique (100) selon l'une des revendications 11 à 15, **caractérisé en ce que** ledit angle au sommet ($\alpha$) et ledit rapport X= D/L satisfont la relation : h1(D/L) < $\alpha$< h2(D/L), avec, pour 0.2$\leq$X<0.5 :

$$h1(X)= 116 - 473*(X + 0.05) + 3962*(X + 0.05)^3 - 6000*(X + 0.05)^4,$$

$$h2(X)=128 - 473*(X - 0.05) + 3962*(X - 0.05)^3 - 6000*(X - 0.05)^4,$$

pour

$$0.5<X\leq0.8:$$

$$h1(X)= 116 - 473*(1.05 - X) + 3962*(1.05 - X)^3 - 6000*(1.05 - X)^4,$$

$$h2(X)=128 - 473*(0.95 - X) + 3962*(0.95 - X)^3 - 6000*(0.95 - X)^4.$$

**17.** Oscillateur mécanique (100) selon l'une des revendications 1 à 16, **caractérisé en ce que** lesdites lames flexibles sont des lames droites

**18.** Mouvement d'horlogerie (1000) comportant au moins un oscillateur (100) mécanique selon l'une des revendications 1 à 17.

**19.** Montre (2000) comportant au moins un mouvement d'horlogerie (1000) selon la revendication 18.

**Patentansprüche**

**1.** Mechanischer Oszillator (100) des Uhrwerks, umfassend, zwischen einem starren Tragelement (4), das direkt oder indirekt auf einer Platine (900) befestigt ist, und einem massiven Trägheitselement (5), einen flexiblen Führungsmechanismus (200), der mindestens zwei erste flexible Lamellen (31; 32) umfasst, die dieses massive Trägheitselement (5) tragen, und die so angeordnet sind, dass sie es in eine Ruheposition zurückführen, wobei dieses massive Trägheitselement (5) so angeordnet ist, dass es in einer Schwingungsebene um diese Ruheposition oszilliert, wobei sich die beiden ersten flexiblen Lamellen (31; 32) nicht berühren, und sich ihre Projektionen auf dieser Schwingungsebene in der Ruheposition in einem Kreuzungspunkt (P) kreuzen, in dessen Nähe die Rotationsachse dieses massiven Trägheitselements (5) senkrecht zu dieser Schwingungsebene verläuft, wobei der flexible Führungsmechanismus (200) **dadurch gekennzeichnet, dass** er mindestens eine obere Ebene (28) umfasst, umfassend zwischen einem oberen Träger (48) und dem massiven Trägheitselement (5) mindestens eine obere Primärlamelle (318), die sich entlang einer ersten Richtung der oberen Lamelle (DL1S) erstreckt, und eine obere Sekundärlamelle (328), die sich in einer zweiten Richtung der oberen Lamelle (DL2S) erstreckt, die sich in der Projektion in einem oberen Kreuzungspunkt (PS) kreuzen, wobei sie einen oberen Drehpunkt definieren, und mindestens eine untere Ebene (29), die einen unteren Drehpunkt definiert und die, zwischen einem unteren Träger (49) und diesem massiven Trägheitselement (5) mindestens eine untere Primärlamelle (319) umfasst, die sich in einer ersten Richtung der unteren Lamelle (DL1I) erstreckt, und eine untere Sekundärlamelle (329), die sich in einer zweiten Richtung der unteren Lamelle (DL2I) erstreckt, die sich in der Projektion in einem unteren Kreuzungspunkt (PI) kreuzen, wobei die Primärlamellen (318, 319) und die Sekundärlamellen (328, 329) die ersten flexiblen Lamellen (31; 32) des flexiblen Führungsmechanismus (200) definieren, **dadurch gekennzeichnet, dass** diese obere Ebene (28) und diese untere Ebene (29) jeweils zwischen dieser Platine (900) und dem oberen Träger (48) bzw. dem unteren Träger (49) einen Translationstisch (308; 309) umfassen, der mindestens einer elastischen Verbindung entlang einer oder zwei Freiheitsachsen in der Schwingungsebene aufweist, deren Translationssteifigkeit geringer ist als die des Drehpunkts der oberen Ebene sowie auch als die des Drehpunkts der unteren Ebene, um eine relative Translation zwischen dieser oberen und dieser unteren Ebene zu ermöglichen, um so die Anpassung der relativen Position der beiden Einspannungen dieser flexiblen Lamellen (31; 32) auf der Seite des oberen Trägers (48) und des unteren Trägers (49) sowie die Änderung der Steifigkeit dieser Translationstische (308; 309) zur Einstellung des Anisochronismus zu ermöglichen.

2. Mechanischer Oszillator (100) des Uhrwerks, umfassend, zwischen einem starren Tragelement (4), das direkt oder indirekt auf einer Platine (900) befestigt ist, und einem massiven Trägheitselement (5) einen flexiblen Führungsmechanismus (200), der mindestens zwei erste flexible Lamellen (31; 32) umfasst, die dieses massive Trägheitselement (5) tragen, und die so angeordnet sind, dass sie es in eine Ruheposition zurückführen, wobei dieses massive Trägheitselement (5) so ausgeführt ist, dass es in einer Schwingungsebene in einem Winkel um diese Ruheposition oszilliert, wobei sich diese zwei ersten flexiblen Lamellen (31; 32) nicht berühren und sich deren Projektionen auf dieser Schwingungsebene in der Ruheposition in einem Kreuzungspunkt (P) schneiden, in dessen Nähe die Rotationsachse dieses massiven Trägheitselements (5) senkrecht zu dieser Schwingungsebene verläuft, **dadurch gekennzeichnet, dass** dieser flexible Führungmechanismus (200) übereinander angeordnet mindestens eine obere Ebene (28) umfasst, umfassend zwischen einem oberen Träger (48) und diesem massiven Trägheitselement (5) mindestens eine obere Primärlamelle (318), die sich entlang einer ersten oberen Lamellenrichtung (DL1S) erstreckt, und eine obere Sekundärlamelle (328), die sich entlang einer zweiten oberen Lamellenrichtung (DL2S) erstreckt, welche sich in Projektion in einem oberen Kreuzungspunkt (PS) schneiden, der einen oberen Drehpunkt definiert; sowie mindestens eine untere Ebene (29), die einen unteren Drehgpunkt definiert und umfassend zwischen einem unteren Träger (49) und diesem massiven Trägheitselement (5) mindestens eine untere Primärlamelle (319), die sich entlang einer ersten unteren Lamellenrichtung (DL1I) erstreckt, und eine untere Sekundärlamelle (329), die sich entlang einer zweiten unteren Lamellenrichtung (DL2I) erstreckt, welche sich in Projektion in einem unteren Kreuzungspunkt (PI) schneiden, wobei die Primärlamellen (318, 319) und die Sekundärlamellen (328, 329) die ersten flexiblen Lamellen (31; 32) des flexiblen Führungmechanismus (200) definieren, dadurch weiter gekennzeichnet, dass dieser zwischen dem Trägheitselement (5) und der Einspannung der unteren Primärlamelle (319) sowie zwischen dem Trägheitselement (5) und der Einspannung der unteren Sekundärlamelle (329) jeweils einen Translationstisch (308; 309) umfasst, der mindestens eine elastische Verbindung mit einem oder zwei Freiheitsgraden in der Schwingungsebene aufweist, und dessen Translationssteifigkeit geringer ist als die dieses oberen Drehpunkts sowie auch geringer als die dieses unteren Drehpunkts, um eine relative Translation zwischen dieser oberen Stufe und dieser unteren Stufe zu ermöglichen, um so die Anpassung der relativen Position der beiden Einspannungen dieser flexiblen Lamellen (31; 32) auf der Seite dieses massiven Trägheitselements (5) sowie die Änderung der Steifigkeit dieser Translationstische (308; 309) zur Einstellung des Anisochronismus zu ermöglichen.

3. Mechanischer Oszillator (100) nach Anspruch 1 oder 2, **dadurch gekennzeichnet, dass** diese elastische Verbindung des oberen Translationstisches (308) bzw. des unteren Translationstischs (309) gemäß einer oder zwei Freiheitsachsen in der Schwingungsebene eine elastische Verbindung nach den X- und Y-Achsen der Winkelhalbierenden der Winkel, die die Projektionen der flexiblen Lamellen des flexiblen Führungsmechanismus (200) miteinander bilden, ist.

4. Mechanischer Oszillator (100) nach einem der Ansprüche 1 bis 3, **dadurch gekennzeichnet, dass** diese beiden Richtungen der Lamellen (DL1; DL2) parallel zum Oszillationsplan verlaufen und in Ruheposition, in der Projektion auf diesen Oszillationsplan, einen Winkel am Scheitelpunkt a bilden, wobei die Position des Kreuzungspunktes (P) durch das Verhältnis X = D/L definiert ist, wobei D der Abstand zwischen der Projektion, auf dieser Schwingungsebene, eines der Einspannpunkte dieser ersten Lamellen (31; 32) im ersten Element der starren Halterung (4) und dem Kreuzungspunkt (P) ist, und wobei L die Gesamtlänge der Projektion, auf dieser Schwingungsebene, dieser Lamelle (31; 32) ist, und dadurch, dass der Schwerpunkt des Oszillators (100) in seiner Ruheposition von diesem Kreuzungspunkt (P) um eine Abweichung ($\varepsilon$) entfernt ist, die zwischen 12 % und 18 % der Gesamtlänge L der Projektion beträgt, auf dieser Schwingungsebene, dieser Lamelle (31; 32), wobei der Wert dieses D/L-Verhältnisses zwischen 0 und 1 liegt, wobei der Winkel am Scheitelpunkt ($\alpha$) kleiner oder gleich 60° ist, und wobei das Einspannverhältnis (D1/L1; D2/L2) für jede dieser ersten flexiblen Lamellen (31; 32) zwischen 0,15 und 0,85, einschließlich der Grenzen, liegt.

5. Mechanischer Oszillator (100) nach einem der Ansprüche 1 bis 3, **dadurch gekennzeichnet, dass** jede dieser Lamellen (31; 32) ein Seitenverhältnis RA = H/E hat, wobei H die Höhe dieser Lamelle (31; 32) senkrecht sowohl zur Oszillationsebene als auch zur Verlängerung dieser Lamelle (31; 32) entsprechend dieser Länge L ist, und E die Dicke dieser Lamelle (31; 32) auf der Oszillationsebene und senkrecht zur Verlängerung dieser Lamelle (31; 32) entsprechend dieser Länge L ist, und dass dieses Seitenverhältnis RA = H/E für jede dieser Lamellen (31; 32) kleiner als 10 ist, und dass die Gesamtzahl dieser flexiblen Lamellen (31; 32) strikt größer als zwei ist.

6. Mechanischer Oszillator (100) nach Anspruch 5, **dadurch gekennzeichnet, dass** der Oszillator (100) eine erste Anzahl N1 dieser ersten Lamellen, genannt Primärlamellen (31), aufweist, die sich in einer ersten Lamellenrichtung (DL1) erstrecken, und eine zweite Anzahl N2 dieser ersten Lamellen, genannt Sekundärlamellen (32), die sich in einer zweiten Lamellenrichtung (DL2) erstrecken, wobei diese erste Zahl N1 und diese zweite Zahl N2 jeweils größer oder gleich zwei sind.

7. Mechanischer Oszillator (100) nach Anspruch 6, **dadurch gekennzeichnet, dass** diese erste Zahl N1 der zweiten Zahl N2 entspricht.

8. Mechanischer Oszillator (100) nach Anspruch 6 oder 7, **dadurch gekennzeichnet, dass** der Oszillator mindestens ein Paar aufweist, das aus einer dieser Primärlamellen (31) besteht, die sich in einer ersten Lamellenrichtung (DL1) erstreckt, und aus einer dieser Sekundärlamellen (32), die sich in einer zweiten Lamellenrichtung (DL2) erstreckt, und dass in jedem Paar diese Primärlamelle (31) bis auf die Ausrichtung identisch mit dieser Sekundärlamelle (32) ist.

9. Mechanischer Oszillator (100) nach Anspruch 8, **dadurch gekennzeichnet, dass** der Oszillator mindestens ein Paar aufweist, das aus einer dieser Primärlamellen (31) besteht, die sich in einer ersten Lamellenrichtung (DL1) erstreckt, und aus einer dieser Sekundärlamellen (32), die sich in einer zweiten Lamellenrichtung (DL2) erstreckt, und dass in jedem Paar diese Primärlamelle (31) bis auf die Ausrichtung identisch mit dieser Sekundärlamelle (32) ist.

10. Mechanischer Oszillator (100) nach Anspruch 6 oder 8 nach 6, **dadurch gekennzeichnet, dass** der Oszillator mindestens eine Gruppe von Lamellen aufweist, die aus einer dieser Primärlamellen (31) besteht, die sich in einer ersten Lamellenrichtung (DL1) erstreckt, und einer Vielzahl dieser Sekundärlamellen (32), die sich in einer zweiten Lamellenrichtung (DL2) erstrecken, und wodurch, in jeder dieser Lamellengruppen, das elastische Verhalten dieser Primärlamelle (31) identisch mit dem elastischen Verhalten ist, das sich aus dieser Vielzahl von Sekundärlamellen (32) abgesehen von der Ausrichtung ergibt.

11. Mechanischer Oszillator (100) des Uhrwerks, nach einem der Ansprüche 1 bis 10, **dadurch gekennzeichnet, dass** diese beiden Lamellenrichtungen (DL1; DL2) parallel zu einer Oszillationsebene, in Ruheposition, bei der Projektion auf diese Oszillationsebene, einen Winkel am Scheitel a bilden, wobei die Position des Kreuzungspunktes (P) durch das Verhältnis X=D/L definiert ist, wobei D der Abstand zwischen der Projektion auf dieser Schwingungsebene eines der Einsatzpunkte dieser ersten Lamellen (31; 32) beim ersten Element der starren Halterung (4) und dem Kreuzungspunkt (P) ist, und wobei L die Gesamtlänge der Projektion auf diese Schwingungsebene dieser Lamelle (31; 32) in ihrer Verlängerung ist, und **dadurch gekennzeichnet, dass** dieser Einbaubericht (D1/L1; D2/L2) zwischen 0,15 und 0,49 liegt, Klemmen inbegriffen, oder zwischen 0,51 und 0,85, Klemmen inbegriffen.

12. Mechanischer Oszillator (100) nach Anspruch 11, **dadurch gekennzeichnet, dass** der Winkel am Scheitel ($\alpha$) kleiner oder gleich 50° ist und **dadurch gekennzeichnet, dass** der Einbauanteil (D1/L1; D2/L2) zwischen 0,25 und 0,75, einschließlich Klemmen, liegt.

13. Mechanischer Oszillator (100) nach Anspruch 12, **dadurch gekennzeichnet, dass** dieser Winkel am Scheitel ($\alpha$) kleiner oder gleich 40° ist, wobei das Einbauverhältnis (D1/L1; D2/L2) zwischen 0,30 und 0,70 einschließlich Klemmen liegt.

14. Mechanischer Oszillator (100) nach Anspruch 13, **dadurch gekennzeichnet, dass** der Winkel am Scheitel ($\alpha$) kleiner oder gleich 35° ist, wobei das Einbauverhältnis (D1/L1; D2/L2) zwischen 0,40 und 0,60 einschließlich Klemmen liegt.

15. Mechanischer Oszillator (100) nach einem der Ansprüche 11 bis 14, **dadurch gekennzeichnet, dass** der Winkel am Scheitel ($\alpha$) kleiner oder gleich 30° ist.

16. Mechanischer Oszillator (100) nach einem der Ansprüche 11 bis 15,
**dadurch gekennzeichnet, dass** der Winkel am Scheitel ($\alpha$) und das Verhältnis X=D/L die Beziehung erfüllen:
h1(D/L) < $\alpha$ < h2(D/L), mit, für 0,2<X<0,5:

$$h1(X) = 116 - 473^*(X + 0,05) + 3962^*(X + 0,05)^3 - 6000^*(X + 0,05)^4, h2(X)$$
$$= 128 - 473^*(X - 0,05) + 3962^*(X - 0,05)^3 - 6000^*(X - 0,05)^4, \text{ für}$$

0,5<X<0,8:

$$h1(X) = 116 - 473^*(1,05 - X) + 3962^*(1,05 - X)^3 - 6000^*(1,05 - X)^4,$$

$$h2(X)=128 - 473*(0,95 - X) + 3962*(0,95 - X)^3 - 6000*(0,95 - X)^4.$$

**17.** Mechanischer Oszillator (100) nach einem der Ansprüche 1 bis 16, **dadurch gekennzeichnet, dass** diese flexiblen Lamellen gerade Lamellen sind.

**18.** Uhrwerk (1000) mit mindestens einem mechanischen Oszillator (100) nach einem der Ansprüche 1 bis 17.

**19.** Uhr (2000) mit mindestens einem Uhrwerk (1000) nach Anspruch 18.

**Claims**

**1.** A mechanical horological oscillator (100) comprising, between a first rigid support element (4) directly or indirectly fixed to a plate (900), and a solid inertial element (5), a flexible guide mechanism (200) comprising at least two first flexible blades (31; 32) which support said solid inertial element (5) and are arranged to return it to a lock position, said solid inertial element (5) being arranged to oscillate angularly in an oscillation plane about said lock position, said two first flexible blades (31; 32) not touching each other and their projections onto said oscillation plane crossing, in the lock position, at a crossing point (P), in proximity to which passes the axis of rotation of said solid inertial element (5) perpendicularly to said oscillation plane, **characterised in that** said flexible guide mechanism (200) comprises, overlapping each other, at least one upper level (28), which comprises, between an upper support (48) and said solid inertial element (5), at least one upper primary blade (318) extending in a first upper blade direction (DL1S) and one upper secondary blade (328) extending in a second upper blade direction (DL2S), crossed in projection at an upper crossing point (PS) defining an upper pivot, and at least one lower level (29) defining a lower pivot and which comprises, between a lower support (49) and said solid inertial element (5), at least one lower primary blade (319) extending in a first lower blade direction (DL1I) and one lower secondary blade (329) extending in a second lower blade direction (DL2I), crossed in projection at a lower crossing point (PI), the primary blades (318, 319) and secondary blades (328, 329) defining the first flexible blades (31; 32) of the flexible guide mechanism (200), **characterised in that** said upper level (28) and said lower level (29) each comprise, between said plate (900) and said upper support (48), and respectively said lower support (49), a translational table (308; 309) comprising at least one resilient connection along one or two axes of freedom in the oscillation plane, and whose translational stiffness is less than that of said pivot of the upper level and also than that of said pivot of said lower level, to allow a relative translation between said upper level and said lower level, in order to allow adjustment of the relative position of the two settings of said flexible blades (31; 32) on the side of said upper support (48) and of said lower support (49), and modification of the stiffness of said translational tables (308; 309) to allow adjustment of the anisochronism.

**2.** A mechanical horological oscillator (100) comprising, between a first rigid support element (4) directly or indirectly fixed to a plate (900), and a solid inertial element (5), a flexible guide mechanism (200) comprising at least two first flexible blades (31; 32) which support said solid inertial element (5) and are arranged to return it to a lock position, said solid inertial element (5) being arranged to oscillate angularly in an oscillation plane about said lock position, said two first flexible blades (31; 32) not touching each other and their projections onto said oscillation plane crossing, in the lock position, at a crossing point (P), in proximity to which passes the axis of rotation of said solid inertial element (5) perpendicularly to said oscillation plane, **characterised in that** said flexible guide mechanism (200) comprises, overlapping each other, at least one upper level (28), which comprises, between an upper support (48) and said solid inertial element (5), at least one upper primary blade (318) extending in a first upper blade direction (DL1S) and one upper secondary blade (328) extending in a second upper blade direction (DL2S), crossed in projection at an upper crossing point (PS) defining an upper pivot, and at least one lower level (29) defining a lower pivot and which comprises, between a lower support (49) and said solid inertial element (5), at least one lower primary blade (319) extending in a first lower blade direction (DL1I) and one lower secondary blade (329) extending in a second lower blade direction (DL2I), crossed in projection at a lower crossing point (PI), the primary blades (318, 319) and secondary blades (328, 329) defining the first flexible blades (31; 32) of the flexible guide mechanism (200), **characterised in that** it comprises, between the inertial element (5) and the setting of the lower primary blade (319), and, respectively, between the inertial element (5) and the setting of the lower secondary blade (329), a translational table (308; 309) comprising at least one resilient connection along one or two axes of freedom in the oscillation plane, and whose translational stiffness is less than that of said pivot of the upper level and also than that of said pivot of said lower level, to allow a relative translation between said upper level and said lower level, in order to allow adjustment of the relative position of the two settings of said flexible blades (31; 32) on the side of solid inertial element (5) and modification of the stiffness of said translational tables (308; 309) to allow adjustment of the anisochronism.

3. The mechanical oscillator (100) according to claim 1 or 2, **characterised in that** said resilient connection of said upper translational table (308) or respectively of said lower translational table (309), along one or two axes of freedom in said oscillation plane, is a resilient connection along the X and Y axes of the bissectors of the angles formed between the projections of the flexible blades of said flexible guide mechanism (200) onto a common parallel plane.

4. The mechanical oscillator (100) according to any of claims 1 to 3, **characterised in that** said two blade directions (DL1; DL2) parallel to said oscillation plane and forming between them, in the lock position, in projection onto said oscillation plane, a vertex angle $\alpha$, the position of said crossing point (P) being defined by the ratio X= D/L, where D is the distance between the projection onto said oscillation plane of one of the settings of said first blades (31; 32) in said first rigid support element (4) and said crossing point (P), and where L is the total length of the projection, onto said oscillation plane, of said blade (31, 32), and **in that** the centre of mass of said oscillator (100) in its lock position, is separated from said crossing point (P) by an offset ($\varepsilon$), which is comprised between 12% and 18% of said total projected length L, onto said oscillation plane, of said blade (31; 32), **in that** the value of said ratio D/L is comprised between 0 and 1, **in that** said vertex angle ($\alpha$) is less than or equal to 60°, and **in that**, for each said first flexible blade (31; 32), the setting ratio (D1/L1; D2/L2) is comprised between 0.15 and 0.85 inclusive.

5. The mechanical oscillator (100) according to any of claims 1 to 3, **characterised in that** each said blade (31; 32) has an aspect ratio RA = H/E, where H is the height of said blade (31; 32) perpendicularly both to the oscillation plane and to the elongation of said blade (31; 32) along said length L, and where E is the thickness of said blade (31; 32) in the oscillation plane and perpendicularly to the elongation of said blade (31; 32) along said length L, and **in that** said aspect ratio RA = H/E is less than 10 for each said blade (31; 32), and **in that** the total number of said flexible blades (31; 32) is strictly greater than two.

6. The mechanical oscillator (100) according to claim 5, **characterised in that** said oscillator (100) comprises a first number N1 of said first blades, called primary blades (31), extending in a first blade direction (DL1), and a second number N2 of said first blades called secondary blades (32) extending in a second blade direction (DL2), said first number N1 and said second number N2 each being greater than or equal to two.

7. The mechanical oscillator (100) according to claim 6, **characterised in that** said first number N1 is equal to said second number N2.

8. The mechanical oscillator (100) according to claim 6 or 7, **characterised in that** said oscillator comprises at least one pair formed of one said primary blade (31) extending in a first blade direction (DL1), and of one said secondary blade (32) extending in a second blade direction (DL2), and **in that**, in each pair, said primary blade (31) is identical to said secondary blade (32), except as regards orientation.

9. The mechanical oscillator (100) according to claim 8, **characterised in that** said oscillator comprises only said pairs each formed of one said primary blade (31) extending in a first blade direction (DL1), and of one said secondary blade (32) extending in a second blade direction (DL2), and **in that**, in each pair, said primary blade (31) is identical to said secondary blade (32), except as regards orientation.

10. The mechanical oscillator (100) according to claim 6 or 8 according to 6, **characterised in that** said oscillator comprises at least one group of blades formed of one said primary blade (31) extending in a first blade direction (DL1), and of a plurality of said secondary blades (32) extending in a second blade direction (DL2) and **in that**, in each said group of blades, the elastic behaviour of said primary blade (31) is identical to the elastic behaviour resulting from said plurality of secondary blades (32) except as regards orientation.

11. The mechanical horological oscillator (100) according to any of claims 1 to 10, **characterised in that** said two blade directions (DL1; DL2) parallel to said oscillation plane form between them, in the lock position, in projection onto said oscillation plane, a vertex angle $\alpha$, the position of said crossing point (P) being defined by the ratio X= D/L, where D is the distance between the projection, onto said oscillation plane, of one of the settings of said first blades (31; 32) in said first rigid support element (4) and said crossing point (P), and L is the total length of the projection, onto said oscillation plane, of said blade (31; 32) in its elongation, and **in that** said setting ratio (D1/L1; D2/L2) is comprised between 0.15 and 0.49 inclusive, or between 0.51 and 0.85 inclusive.

12. The mechanical oscillator (100) according to claim 11, **characterised in that** said vertex angle ($\alpha$) is less than or equal to 50°, and **characterised in that** said setting ratio (D1/L1; D2/L2) is comprised between 0.25 and 0.75 inclusive.

13. The mechanical oscillator (100) according to claim 12, **characterised in that** said vertex angle ($\alpha$) is less than or equal to 40°, and **in that** said setting ratio (D1/L1; D2/L2) is comprised between 0.30 and 0.70 inclusive.

14. The mechanical oscillator (100) according to claim 13, **characterised in that** said vertex angle ($\alpha$) is less than or equal to 35°, and **in that** said setting ratio (D1/L1; D2/L2) is comprised between 0.40 and 0.60 inclusive.

15. The mechanical oscillator (100) according to any of claims 11 to 14, **characterised in that** said vertex angle ($\alpha$) is less than or equal to 30°.

16. The mechanical oscillator (100) according to any of claims 11 to 15, **characterised in that** said vertex angle ($\alpha$) and said ratio X= D/L satisfy the relation h1(D/L) < $\alpha$< h2(D/L), where,
for 0.2$\leq$X<0.5:

$$h1(X)= 116 - 473^{*}(X + 0.05) + 3962^{*}(X + 0.05)^{3} - 6{,}000^{*}(X+0.05)^{4},$$

$$h2(X)=128 - 473^{*}(X - 0.05) + 3{,}962^{*}(X - 0.05)^{3} - 6{,}000^{*}(X-0.05)^{4},$$

for

$$0.5<X\leq0.8:$$

$$h1(X)= 116 - 473^{*}(1.05 - X) + 3{,}962^{*}(1.05 - X)^{3} - 6{,}000^{*}(1.05 - X)^{4},$$

$$h2(X)=128 - 473^{*}(0.95 - X) + 3{,}962^{*}(0.95 - X)^{3} - 6{,}000^{*}(0.95 - X)^{4}.$$

17. The mechanical oscillator (100) according to any of claims 1 to 16, **characterised in that** said flexible blades are straight blades.

18. A horological movement (1000) comprising at least one mechanical oscillator (100) according to any of claims 1 to 17.

19. A watch (2000) comprising at least one horological movement (1000) according to claim 18.

Fig. 1

1

4

5

100

Fig. 2

100

5

4

1

A

A

ε

Fig. 3

100

5

4

1

ε

Fig. 4

Fig. 5

Fig. 9

Fig. 6

Fig. 7

Fig. 8

Fig. 10

Fig. 11

Fig. 12

Fig. 13

Fig. 14

Fig. 15

Fig. 16

Fig. 17

Fig. 18

# Fig. 19

# Fig. 20

# Fig. 21

# Fig. 22

# Fig. 23

# Fig. 24

## Fig. 25

## Fig. 26

## Fig. 27

## Fig. 28

## RÉFÉRENCES CITÉES DANS LA DESCRIPTION

**Documents brevets cités dans la description**

- EP 3035126 A1
- EP 3206089 A1
- EP 3035127 A1
- US 3628781 A
- EP 3324247 A1
- EP 2998800 A2
- EP 3130966 A1
- CH 709536 A2
- EP 3435170 A1

**Littérature non-brevet citée dans la description**

- **M. H. KAHROBAIYAN**. Lors du Congrès de Chronométrie de Montreux, Suisse. *Gravity insensitive flexure pivots for watch oscillators*, 28 September 2016
- **LARRY L. HOWELL**. Handbook of compliant mechanisms. WILEY
- **ZEYI WU** ; **QINGSONG XU**. *Actuators*, 2018